# EUROPÄISCHE PATENTSCHRIFT

(11) **EP 4 347 141 B1**
(45) Veröffentlichungstag und Bekanntmachung des Hinweises auf die Patenterteilung: **19.11.2025**
(21) Anmeldenummer: 22731201.4
(22) Anmeldetag: 31.05.2022
(51) Int. Cl.: B05C 5/02

(54) **DOSIERSYSTEM**
METERING SYSTEM
SYSTÈME DE DOSAGE

(30) Priorität: 02.06.2021 DE 102021114302
(43) Veröffentlichungstag der Anmeldung: 10.04.2024
(73) Patentinhaber: Vermes Microdispensing GmbH, 83607 Holzkirchen (DE)
(72) Erfinder: SCHMIDBERGER, Simon, 83052 Bruckmühl (DE); FLIESS, Mario, 81549 München (DE)
(74) Vertreter: Beckord & Niedlich Patentanwälte PartG mbB
(86) Internationale Anmeldenummer: PCT/EP2022/064801
(87) Internationale Veröffentlichungsnummer: WO 2022/253850

(56) Entgegenhaltungen:
- CN-B- 102 935 416
- KR-B1- 101 819 077
- US-A1- 2019 022 692

## Beschreibung

Die Erfindung betrifft ein Dosiersystem mit einem Gehäuse, einem darin befindlichen Piezo-Aktor, einer Fluidikeinheit mit einem Ventil, einer Stößelvorrichtung zum Verschließen des Ventils und einem Übersetzungshebel zur Kopplung des Piezo-Aktors mit der Stößelvorrichtung.

Dosiersysteme werden üblicherweise dazu eingesetzt, ein zu dosierendes Medium, typischerweise einen flüssigen bis zähflüssigen Dosierstoff, gezielt, beispielsweise durch eine tröpfchenweise bzw. dosierpunktartige Abgabe des Dosiermediums mittels der Stößelvorrichtung über ein Ventil des Dosiersystems, zu dosieren. Bei einer solchen Abgabe lässt sich also in einem einzelnen Dosierschritt (sehr einfach ausgedrückt bei einer einzelnen Öffnungsbewegung der Stößelvorrichtung) beispielsweise ein Dosierpunkt bzw. "Klecks" (Tropfen) an einer Stelle auf einem Werkstück platzieren.

Im Rahmen der sogenannten "Mikrodosiertechnik" ist es weiterhin oftmals erforderlich, dass sehr geringe Mengen des Dosiermediums bzw. Dosierstoffs punktgenau, und zwar berührungslos, d. h. ohne einen direkten Kontakt zwischen dem Dosiersystem und einer Zieloberfläche, auf eine Zieloberfläche aufgebracht werden. Ein solches kontaktloses Verfahren wird häufig auch als "Jet-Verfahren" bezeichnet. Ein typisches Beispiel dafür ist die Dosierung von Klebstoffpunkten, Lötpasten etc. bei der Bestückung von Leiterplatinen oder anderen elektronischen Elementen oder die Aufbringung von Konverter-Materialien für LEDs.

Aus der EP 1 414 080 A2 ist beispielsweise ein piezoelektrisches Aktorsystem bzw. Positioniersystem mit einem Piezo-Aktor und einer integrierten Hebelübersetzung bekannt, bei welchem sich der Piezo-Aktor auf einer vom Ventil abgewandten Seite vom Übersetzungshebel weg erstreckt. Diese Anordnung hat den Nachteil, dass das Aktorsystem konstruktionsbedingt in die Länge gezogen wird bzw. unvorteilhaft lang ausfallen muss.

Aus der KR 101 819 077 B1, der US 2019/022692 A1 und der CN 102 935 416 B sind Dosiersysteme bekannt, bei denen sich der Piezo-Aktor auf einer vom Ventil zugewandten Seite im Wesentlichen parallel zum Stößel vom Übersetzungshebel weg erstreckt. Bei der KR 101 819 077 B1 und der US 2019/022692 A1 ist der Stößel über eine einzelne Feder relativ zum Gehäuse verspannt, womit der Stößel stets in eine Verschlussstellung gedrückt wird.

Es ist daher eine Aufgabe der vorliegenden Erfindung, die Nachteile des Stands der Technik zu überwinden und ein besonders kompaktes Dosiersystem anzugeben.

Diese Aufgabe wird durch ein Dosiersystem nach Patentanspruch 1 gelöst.

Wie eingangs erwähnt umfasst das Dosiersystem ein Gehäuse. Unter dem Gehäuse ist sowohl eine überwiegend geschlossene äußere Hülle zu verstehen, als auch innere Strukturen, in welchen die darin befindlichen Komponenten passend gelagert sind.

Eine dieser Komponenten ist der ebenfalls eingangs bereits erwähnte längliche Piezo-Aktor. Dieser dient dazu einen Impuls bzw. eine Dosierbewegung zu erzeugen, welche über den Übersetzungshebel auf die Stößelvorrichtung übertragen wird, um das Ventil zu öffnen oder zu schließen. Der Piezo-Aktor kann dazu vorteilhafterweise in das Gehäuse eingepasst sein. Dabei kann er vorzugsweise auch eine Kapselung aufweisen, d. h. der eigentliche Piezo bzw. Piezo-Stack kann eingekapselt sein, um ihn gegen Feuchtigkeit zu schützen. Der gekapselte Piezo-Aktor kann dann effektiver gekühlt werden.

Bei dem erwähnten Ventil der Fluidikeinheit kann es sich insbesondere um ein sogenanntes "Jet-Ventil" handeln, also um ein Ventil, welches sich zum "Jetten" eignet bzw. in einem Jet-Verfahren betrieben werden kann. Bei dieser Betriebsweise dient die Stößelvorrichtung in erster Linie als Ausstoßelement, d. h. bei der Bewegung des Stößels zu einem Ventilsitz bzw. Dichtsitz des Ventils hin wird vom Stößel das Dosiermaterial bzw. der Dosierstoff ausgestoßen. Zusätzlich oder alternativ kann ein Teil der Stößelvorrichtung von seiner Funktionsart her auch als tatsächliches Verschlusselement fungieren, welches das Ventil jeweils im Zuge der Dosierbewegung verschließt, indem der Stößel in einer Endstellung in den Ventilsitz drückt. Wenn das Dosiermaterial aufgrund anderer Kräfte, z. B. der Schwerkraft und/oder einem gegenüber der Umgebung erhöhten Druck im Ventil, aus dem Ventil austreten kann, kann also auch dosiert werden, indem einfach durch Zurückziehen des Stößels aus dem Ventilsitz, das Ventil geöffnet und nach Abgabe der gewünschten Dosiermenge wieder geschlossen wird. Dabei kann die Stößelvorrichtung je nach Anwendung in den unterschiedlichen Funktionsarten betrieben werden, indem der Stößel der Stößelvorrichtung als Verschlusselement des Ventils und/oder als Ausstoßelement ("Jetten") dient. Beide Funktionsarten können praktische Relevanz haben.

Weiterhin im Gehäuse aufgenommen ist auch der besagte Übersetzungshebel. Dieser dient zur Kopplung des Piezo-Aktors mit der Stößelvorrichtung. Der Übersetzungshebel kann seinerseits über eine Welle in einem Hebellager des Gehäuses gelagert sein, so dass sich der Übersetzungshebel relativ zur Welle bzw. Kippachse kippen lässt.

Bei der Welle kann es sich beispielsweise um einen Linienkontakt bzw. ein Wälzlager handeln, wie es aus der EP 1 414 080 A2 bereits bekannt ist.

Die eingangs genannte Fluidikeinheit mit dem Ventil kann beispielsweise so ausgebildet sein, dass sie sich an das Gehäuse koppeln lässt, um das Dosiersystem im Wesentlichen mit Dosierstoff zu versorgen, damit der Dosierstoff dann wiederum mittels der Stößelvorrichtung durch das Ventil in gewünschter Dosierung abgegeben werden kann. Bis auf die Teile der Stößelvorrichtung (wie unten noch erläutert wird) umfasst die Fluidikeinheit im Wesentlichen alle Komponenten, die der Bereitstellung, Temperierung etc. des Dosierstoffs dienen.

Dabei ist der Piezo-Aktor im Wesentlichen neben der Stößelvorrichtung im Gehäuse angeordnet, insbesondere ausgerichtet. "Im Wesentlichen neben" meint, dass die beiden Komponenten räumlich gesehen dicht beieinander liegen.

Erfindungsgemäß erstreckt sich der Piezo-Aktor in Richtung einer zum Ventil weisenden Seite vom Übersetzungshebel aus weg im Wesentlichen in Richtung Ventil. Mit anderen Worten verlaufen Piezo-Aktor und Stößelvorrichtung nebeneinander bzw. im Wesentlichen parallel zueinander im Gehäuse von einem der beiden Hebelarme des Übersetzungshebels weg.

Zudem ist der Piezo-Aktor über den Übersetzungshebel mit der Stößelvorrichtung mittels einer Federanordnung relativ zum Gehäuse verspannt.

Weiterhin weist die Federanordnung zur gefederten Verspannung der Stößelvorrichtung mehrere Federn bzw. Federelemente auf.

An dieser Stelle sei der Einfachheit halber darauf hingewiesen, dass im Folgenden ohne Beschränkung der Allgemeinheit eine Richtung zum Ventil auch als eine Richtung nach unten und eine Richtung vom Ventil weg zum Übersetzungshebel als eine Richtung nach oben bezeichnet wird. Relative Richtungsangaben wie "oberhalb", "unterhalb", etc. (weitere sind weiter unten noch aufgeführt) sind daher entsprechend zu verstehen, wenn gleich das Dosiersystem nicht auf eine Dosierung in dieser Anordnung beschränkt ist.

Die erfindungsgemäße Anordnung ermöglicht eine besonders kompakte Konstruktion, wodurch das Dosiersystem insgesamt deutlich kürzer ausfallen kann, als dies mit den aus dem Stand der Technik bekannten Lösungen möglich ist. Dabei nutzt sie den Platz im Gehäuse optimal aus, so dass die längeren Komponenten, wie die längliche Stößelvorrichtung oder der Piezo-Aktor nicht unnötig Platz benötigen, d. h. sich von der Länge her beispielsweise im Wesentlichen aufaddieren, wie dies bisher in den Konstruktionen des Stands der Technik der Fall war.

Die erfindungsgemäße Konstruktion schafft zudem zusätzlichen Platz in der Länge, welcher - wie weiter unten noch erläutert wird - dazu genutzt werden kann, dass das wesentliche Verschleißteil des gesamten Dosiersystems, nämlich ein Stößel der Stößelvorrichtung, welcher wie gesagt je nach gewählter Funktionsart, in der das Dosiersystem betrieben wird, als Verschlusselement oder als Ausstoßelement fungiert, einfach und schnell für den Kunden tauschbar verbaut werden kann. Zudem kann damit das Dosiersystem, welches von seiner Bauart ursprünglich für einen sogenannten normal geschlossenen ("normallyclosed"), d. h. "in der Ausgangsstellung geschlossenen Betrieb bzw. Dosierbetrieb" ausgelegt ist, bei gleicher Länge auch Komponenten nutzen, welche nun sowohl für normal geöffnete als auch für normal geschlossene Dosiersysteme einsetzbar sind (etwa der Stößel und die Fluidikeinheit). Bei einem im stromlosen Zustand des Dosiersystems normal geöffneten bzw. offenen ("normally-open") Ventil ist das Verschlusselement - wenn keine Spannung am Dosiersystem anliegt - nicht in den Dichtsitz im Ventil gedrückt, sondern weist einen kleinen Abstand dazu auf. Wird ein solches Dosiersystem in einen Dosierbetrieb hochgefahren, d. h. angeschaltet, wird das Dosiersystem zunächst so mit Spannung beaufschlagt, dass das Verschlusselement dann in einer initialen Ausgangsstellung für den Dosierbetrieb geschlossen ist.

Dabei kann dann vor jedem Dosierimpuls das Verschlusselement im Ventilsitz im Ventil bzw. in einer Düse des Ventils angeordnet sein und von dort bei einer Dosierbewegung aus dieser initialen Ausgangsstellung minimal angehoben und anschließend wieder abgesenkt werden, so dass je nach Stellung und Öffnungsdauer entsprechend Dosierstoff austreten kann. Im Jet-Verfahren wird dabei zusätzlich Dosierstoff ausgestoßen, denn der Stößel fungiert dann wie gesagt als Ausstoßelement und stößt Dosierstoff aus, wenn er als Ausstoßelement auf den Ventilsitz zum Verschließen zufährt.

Unabhängig von der Funktionsart des Stößels ist es oft von Vorteil, wenn der Dosierstoff eine ausreichende Viskosität aufweist, so dass er aufgrund seiner Zähflüssigkeit nicht von selbst aus dem Ventil ausfließt bzw. ausläuft, auch wenn das Ventil geöffnet ist. Dennoch lässt es sich manchmal nicht vermeiden, dass auch niederviskose Dosierstoffe zu dosieren sind.

Bei einem in der initialen Ausgangsstellung geschlossenen Dosierbetrieb ist daher das Verschlusselement, wann immer gerade nicht dosiert wird, z. B. im stromlos geschalteten Zustand oder im Störungs- bzw. Fehlerfall, vorzugsweise automatisch durch eine geeignet eingestellte Feder aufgrund der Federspannung in einem sogenannten Ventilsitz bzw. Dichtsitz im Ventil angeordnet. Das heißt, dass dann das Ventil tatsächlich mit dem darin angeordneten Verschlusselement ausreichend dicht verschlossen ist, so dass auch ein sehr flüssiger, niederviskoser Dosierstoff nicht austreten kann. Dieser Dosierbetrieb eignet sich daher gerade für besonders flüssige Dosierstoffe oder wenn der Dosierstoff wie erwähnt mit zusätzlichem Druck aus dem Ventil dosiert werden soll.

Weitere, besonders vorteilhafte Ausgestaltungen und Weiterbildungen der Erfindung ergeben sich aus den abhängigen Ansprüchen sowie der nachfolgenden Beschreibung, wobei auch einzelne Merkmale verschiedener Ausführungsbeispiele bzw. Varianten zu neuen Ausführungsbeispielen bzw. Varianten kombiniert werden können.

Vorzugsweise kann sich der Übersetzungshebel quer zu einer Erstreckungsrichtung des Piezo-Aktors und einer Erstreckungsrichtung der Stößelvorrichtung erstrecken. Damit ist gemeint, dass der Übersetzungshebel von der länglichen Stößelvorrichtung quer in einer querverlaufenden Erstreckungsrichtung zum länglichen Piezo-Aktor verläuft.

Vorzugsweise können die Erstreckungsrichtungen des Piezo-Aktors sowie der Stößelvorrichtung im Wesentlichen gleich sein.

Per Definition bezeichnet "quer" bevorzugt nahezu im rechten Winkel zu einer als Länge angenommenen Linie. Insofern wird, sofern die Erstreckungsrichtungen der Stößelvorrichtung und des Piezo-Aktors gleich sind, unter "quer" hier bevorzugt im Wesentlichen im rechten Winkel zu den Erstreckungsrichtungen der beiden Komponenten verstanden. Sofern die Erstreckungsrichtungen des Piezo-Aktors und der Stößelvorrichtung leicht divergieren bzw. konvergieren, also die Komponenten nicht exakt parallel verlaufen, kann quer auch nur von der einen Komponente quer zu anderen Komponente meinen, also beispielsweise leicht schräg bzw. in einem von 90° unwesentlich lediglich um wenige Grad abweichenden Winkel.

Besonders bevorzugt kann sich der Übersetzungshebel also im Wesentlichen senkrecht zu einer Erstreckungsrichtung des Piezo-Aktors und einer Erstreckungsrichtung der Stößelvorrichtung erstrecken.

Indem sich der Übersetzungshebel quer, vorzugsweise im Wesentlichen senkrecht, zu einer Erstreckungsrichtung des Piezo-Aktors und einer Erstreckungsrichtung der Stößelvorrichtung erstreckt, wird die Impulsübertragung der Auslenkung bzw. des Impulses des Piezo-Aktors über den Übersetzungshebel auf die Stößelvorrichtung maximiert. Der Piezo-Aktor kann damit (sofern es sich wie vorgesehen um eine Konfiguration des Dosiersystems handelt, in der das Ventil im stromlosen Zustand durch die Stößelvorrichtung geschlossen ist) zur Dosierung in einem stromführenden Dosierbetrieb über den Übersetzungshebel ein "Öffnungsmoment" auf die Stößelvorrichtung ausüben bzw. eine Kraft auf die Stößelvorrichtung übertragen, die zu einer Bewegung der Stößelvorrichtung weg vom Ventil, also zu einer Art "Hubbewegung" führt, wie weiter unten noch genauer erläutert wird. Zusätzlich lässt sich das Gehäuse sehr kompakt, besonders bevorzugt im Wesentlichen quaderförmig, ausbilden, da sich die größeren, länglichen Komponenten im Wesentlichen nur in zwei orthogonale Richtungen zueinander erstrecken und damit Auswüchse bzw. Auskragungen durch schräg dazu verlaufende Komponenten weitestgehend vermieden werden können.

Wie erwähnt ist der Piezo-Aktor über den Übersetzungshebel mit der Stößelvorrichtung mittels einer Federanordnung relativ zum Gehäuse verspannt. Unter der Federanordnung ist zumindest ein Federelement wie z. B. eine Vorspannfeder, insbesondere eine Druckschraubenfeder, gemeint, welche den Übersetzungshebel direkt oder indirekt gegen das umliegende Gehäuse des Dosiersystems verspannt bzw. vorspannt.

Dies sorgt, wie ebenfalls bereits in der EP 1 414 080 A2 erwähnt worden ist, dafür, dass das Dosiersystem bei extern auf das Dosiersystem einwirkenden Kräften nicht entspannt wird und so die Komponenten geeignet zusammengehalten werden.

Vorzugsweise kann der Übersetzungshebel kippbar an einer Kippachse in Form einer Welle an einer zum Piezo-Aktor weisenden Seite der Welle eingespannt sein. D. h. der Übersetzungshebel wird zwischen Welle und Piezo-Aktor gehalten.

Die Welle wiederum kann vorzugsweise jeweils endseitig in einem Hebellager auf einer ventilabgewandten Seite bzw. Oberseite befestigt sein. Damit ist gemeint, dass die Welle z. B. drehfest gelagert ist und sich der Übersetzungshebel gegen die drehfeste Welle verkippt.

Alternativ könnte beispielsweise im Übersetzungshebel auf einer vom Piezo-Aktor abgewandten Hebelseite eine Mulde ausgespart oder eingeformt sein, in die die Welle zur Befestigung z. B. drehfest eingepresst sein könnte. Dann würde sich die Welle in seitlichen Öffnungen im Hebellager drehen.

Grundsätzlich könnte der Übersetzungshebel beispielsweise über zwei im Wesentlichen symmetrische, also zumindest gleichlange Hebelarme verfügen, d. h. im Wesentlichen mittig um die Kippachse gelagert sein.

Vorzugsweise kann der Übersetzungshebel außermittig gelagert und asymmetrisch ausgebildet sein, d. h. einen kurzen und einen relativ dazu längeren Hebelarm aufweisen. Ein solcher Übersetzungshebel wird weiter unten noch anhand eines bevorzugten Ausführungsbeispiels genauer erläutert.

Wenn es sich um einen Übersetzungshebel mit einem kurzen und einem relativ dazu längeren Hebelarm handelt, kann der Übersetzungshebel - um Platz zu sparen - besonders bevorzugt außermittig am zuvor erwähnten Endabschnitt kippbar eingespannt sein.

Dabei kann vorzugsweise der Piezo-Aktor zum Öffnen des Ventils kippachsennah am langen Hebelarm an einer Aktorangriffsstelle im rechten Winkel zur Kippachse am Übersetzungshebel unter Bildung eines Rolllagers anstehen. Dadurch kann der Übersetzungshebel im Betrieb bei einer Auslenkung des Piezo-Aktors zusammen mit der kippachsenfern, also weiter weg von der Kippachse als die kippachsennahe Aktorangriffsstelle, am langen Hebelarm aufliegenden Stößelvorrichtung in Richtung einer geöffneten Ventilstellung vom Ventil wegbewegt bzw. aus einem dichten Ventilsitz hinausbewegt werden. Die relativen Begriffe "kippachsennah" und "kippachsenfern" beziehen sich hier jeweils auf Punkte bzw. Positionen in einer Längsrichtung des Übersetzungshebels relativ zur Kippachse, an der der Übersetzungshebel kippbar gelagert ist. Kippachsennah meint dementsprechend einfach eine Stelle bzw. einen Punkt entlang der Längsrichtung bzw. der oben erwähnten querverlaufenden Erstreckungsrichtung des Übersetzungshebels, welcher Punkt näher an der Kippachse liegt als ein kippachsenferner Punkt.

Vorzugsweise kann die Stößelvorrichtung aus zumindest zwei Stangenelementen ausgebildet sein, die gegeneinander verspannt sind. Gegeneinander verspannt meint, dass auf die Stangenelemente eine Kraft wirkt, die die Stangenelemente permanent gegeneinanderdrückt, so dass diese dauerhaft in Druckkontakt stehen.

Dabei kann die Stößelvorrichtung besonders bevorzugt hebelseitig ein Übertragungselement als ein erstes Stangenelement aufweisen. Nachfolgend wird das Übertragungselement auch als "Pleuelstange" bzw. "Pleuel" bezeichnet, da es, wie im weiteren Verlauf noch deutlicher wird, bevorzugt als eine Art "Pleuelstange" fungiert, also eine leichte Kreisbahnbewegung ausführt.

Weiter kann die Stößelvorrichtung besonders bevorzugt ventilseitig ein Verschlusselement als ein zweites Stangenelement aufweisen. Das Verschlusselement wird im Folgenden wie auf diesem technischen Gebiet üblich auch als "Ventilstößelstange" bzw. kurz "Stößel" bezeichnet.

Mit der besagten Merkmalskombination wird erreicht, dass die Bewegung des Übersetzungshebels, welche Bewegung konstruktionsbedingt sowohl Axial- als auch Querkomponenten umfasst, nicht direkt auf das ventilseitige Verschlusselement der Stößelvorrichtung übertragen wird, sondern erst indirekt über das hebelseitige Übertragungselement auf das Verschlusselement, da das Übertragungselement im Druckkontakt mit einem hebelseitigen Stößelkopf des Verschlusselements bzw. Stößels steht. Aufgrund des reinen Druckkontaktes und da das Verschlusselement vorteilhafterweise noch überwiegend axial geführt sein kann, werden bei der Übertragung der Bewegung des Übertragungselements auf das Verschlusselement nahezu keine Querkomponenten übertragen.

Somit kann der ventilseitige Stangenteil der Stößelvorrichtung, also das Verschlusselement eine rein axiale Bewegung möglichst frei von den besagten Querkomponenten ausführen, um beispielsweise im stromlosen bzw. spannungsfreien Zustand des Dosiersystems das Ventil mit einer ventilseitigen Stößelspitze des Verschlusselements bzw. Stößels in einem sogenannten Ventilsitz bzw. Dichtsitz im Ventil sicher abzudichten. Dies erleichtert es, dass das Verschlusselement möglichst exakt gerade in den Ventilsitz geführt bzw. gedrückt werden kann und verringert das Risiko, dass möglicherweise für einen besonders niederviskosen Dosierstoff keine ausreichende Abdichtung des Ventils mehr gewährleistet werden kann.

Weiterhin unterstützt die Zweiteilung der Stößelvorrichtung in zwei gegeneinander verspannte Stangenteile, dass das Übertragungselement, welches ja im direkten Kontakt mit dem Übersetzungshebel steht, eine Pleuelbewegung beschreiben kann, welche den Verschleiß einer potenziellen Reibstelle zwischen Stößelvorrichtung und Übersetzungshebel, die bei einer axialen Zwangsführung vorliegen würde, minimiert.

Zudem lässt sich damit der ventilseitige Teil, welcher erfahrungsgemäß dem meisten Verschleiß ausgesetzt ist, gesondert bzw. separat austauschen, ohne dass dafür das Dosiersystem zerlegt werden muss bzw. die Stößelvorrichtung als Ganzes getauscht werden muss.

Für die Ausgestaltung der Federanordnung gibt es verschiedene Möglichkeiten.

Wie erwähnt weist die Federanordnung zur gefederten Verspannung der Stößelvorrichtung mehrere Federn bzw. Federelemente auf. Sie kann beispielsweise eine Feder bzw. ein Federelement aufweisen, welches die Stößelvorrichtung ventilseitig, d. h. auf der im eingebauten Zustand zum Ventil weisenden Seite, oder auf einer ventilabgewandten Seite des Übersetzungshebels gegen den Übersetzungshebel drückt, so dass diese Komponenten im Druckkontakt zueinander stehen. Zusätzlich oder alternativ könnte sie zum Beispiel eine Feder aufweisen, welche die Stößelvorrichtung in einem stromlosen Zustand des Dosiersystems in eine geöffnete Ventilstellung knapp oberhalb eines Ventilsitzes drückt, d. h. die Stößelvorrichtung verschließt das Ventil der Fluidikeinheit nicht im stromlosen Zustand. Wie bereits oben erwähnt, bietet sich ein solcher normalerweise geöffneter Betriebsmodus des Dosiersystems an, wenn das Dosiermedium ohnehin beispielsweise entsprechend viskos bzw. hochviskos ist und damit auch unter der Schwerkraft nicht von allein bereits aus der geöffneten Ventilöffnung ausfließt.

Die Federanordnung kann aber auch so gestaltet sein, dass das Dosiersystem in einem stromlos geschalteten Zustand ein verschlossenes Ventil aufweist, d. h. die Stößelvorrichtung, bzw. der Stößel der Stößelvorrichtung, wird in den Ventilsitz gedrückt. Ein solcher normalerweise geschlossener Betriebsmodus des Dosiersystems bietet sich wie erwähnt bei niederviskoseren Medien an, welche dazu neigen würden, bereits aufgrund der Schwerkraft aus dem geöffneten Ventil auszutreten bzw. auszulaufen.

Weiter bevorzugt kann die Federanordnung demnach zumindest eine Öffnungsfederanordnung zum Öffnen des Ventils und zumindest eine Verschlussfederanordnung zum Schließen des Ventils umfassen, wobei die Verschlussfederanordnung relativ zur Öffnungsfederanordnung eine größere, z. B. die doppelte, Federrate und/oder Vorspannkraft aufweist.

Eine solche Federanordnung sorgt dafür, dass das Ventil im stromlosen Zustand stets geschlossen ist und bleibt, da die Federkraft der Verschlussfeder gegenüber der entgegengesetzt wirkenden Federkraft der Öffnungsfeder überwiegt. Erst ab einem Punkt, an dem der Übersetzungshebel zusammen mit der Öffnungsfeder aufgrund eines Impulses des Piezo-Aktors die Kraft der Verschlussfeder mindestens egalisiert, beginnt sich das Ventil automatisch bzw. zwangsläufig zu öffnen. Mit anderen Worten öffnet die Öffnungsfeder das Ventil automatisch, wenn der Übersetzungshebel die Verschlussfeder vom Ventil wegdrückt.

Die Verschlussfederanordnung kann dabei einfach eine einzelne Verschlussfeder aufweisen, die zur Öffnungsfederanordnung (welche auch nur eine einzelne Öffnungsfeder aufweisen kann) die größere bzw. doppelte Federrate und/oder Vorspannkraft aufweist. Anstatt einer Verschlussfeder mit relativ zur Öffnungsfeder doppelter Federrate und/oder Vorspannkraft kann die Federanordnung aber besonders bevorzugt auch zwei, z. B. im Wesentlichen baugleiche, gleichläufig jedoch gegenläufig zur Öffnungsfeder arbeitende Verschlussfedern mit jeweils in erster Näherung in Bezug auf eine einzelne Verschlussfeder halber, ansonsten aber in Bezug auf die andere Verschlussfeder gleicher Federrate und Vorspannkraft umfassen. Im Folgenden wird - was einer bevorzugten Variante entspricht - immer von zwei Verschlussfedern (mit halber Federrate und Vorspannkraft) anstatt einer Verschlussfeder (mit der doppelten Federrate und Vorspannkraft) gesprochen. Dies soll nicht beschränkend insoweit wirken, dass nachfolgend stets mindestens zwei Verschlussfedern benötigt werden. Prinzipiell können auch im Folgenden die zwei Verschlussfedern stets mit einer entsprechenden Feder, ggf. an einer anderen Position ersetzt werden, zumindest wenn nichts Anderslautendes dazu vermerkt ist. Denn eine doppelt so starke Verschlussfeder hat, in erster Näherung, die gleiche Funktion wie zwei halb so starke schließende Federn. Ein Vorteil zweier Federn gegenüber einer einzelnen liegt darin, dass sie variabler, insbesondere an verschiedenen Positionen, einsetzbar sind, wie weiter unten noch genauer erläutert wird.

Ganz besonders bevorzugt kann die Federanordnung zwei gleichläufig jedoch gegenläufig zur Öffnungsfeder arbeitende Verschlussfedern mit jeweils in erster Näherung zur Öffnungsfeder im Wesentlichen gleicher Federrate und Vorspannkraft umfassen, so dass also einer bestimmten Öffnungsfederkraft nahezu die doppelte Verschlussfederkraft entgegensteht.

An dieser Stelle sei erwähnt, dass die Federanordnung grundsätzlich verschiedene Federtypen, wie z. B. Zugfedern, Wellenfedern, Tellerfedern, Torsionsfedern etc. umfassen kann. Besonders bevorzugt kann die Federanordnung Druckschraubenfedern umfassen. Mögliche Formen für solche Druckschraubenfedern bzw. Druckfedern, die sich besonders anbieten, sind beispielsweise zylindrische, kegelförmige, tonnenförmige, taillenförmige Druckfedern.

Vorzugsweise kann die Öffnungsfederanordnung bzw. die Öffnungsfeder (im Folgenden wird die Öffnungsfederanordnung auch - ohne Beschränkung der Allgemeinheit - kürzer als Öffnungsfeder bezeichnet) das oben bereits erwähnte Verschlusselement derart federnd im Gehäuse einspannen, dass auf das Verschlusselement eine Kraft wirkt, um das Verschlusselement in Richtung einer geöffneten Ventilstellung zu verbringen.

Dabei können die Verschlussfedern das Übertragungselement derart federnd im Gehäuse verspannen, dass auf das Übertragungselement eine - im Verhältnis zur Öffnungsfeder zumindest etwas größere - gegenläufige Kraft wirkt, um das Übertragungselement gegen das Verschlusselement und damit das Verschlusselement in Richtung einer geschlossenen Ventilstellung zu verbringen. Wie bereits oben angedeutet, ermöglicht der Aufbau der federnd gelagerten Stößelvorrichtung, dass sich Komponenten nutzen lassen, welche nun sowohl für normal geöffnete, als auch für normal geschlossene Dosiersysteme einsetzbar sind (etwa der Stößel und die Fluidikeinheit).

Wie bereits in der EP 1 414 080 A2 erwähnt, kann hier die Federanordnung des Dosiersystems ebenfalls mindestens eine radial äußere große Druckschraubenfeder umfassen, die zumindest eine der bereits erwähnten im Verhältnis kleineren verschließenden Druckschraubenfedern bzw. Verschlussfedern platzsparend umgreift. Durch die Druckschraubenfeder, im Folgenden aufgrund ihrer Funktion auch als Vorspannfeder bezeichnet, lässt sich der Übersetzungshebel kippachsenfern zu seiner Kippachse am langen Hebelarm, also weiter weg von der Kippachse als die kippachsennahe Aktorangriffsstelle am selbigen, separat relativ zum Gehäuse gegen den Piezo-Aktor vorspannen. Mittels der Vorspannung des Piezo-Aktors wird erreicht, dass dieser nach einer Auslenkung schneller wieder vollständig in seine Ausgangslage zurückgeführt werden kann.

Im Gegensatz zur EP 1 414 080 A2, kann der Übersetzungshebel vorzugsweise derart vorgespannt bzw. die Vorspannung derart eingestellt sein, dass das Ventil, indem zumindest eine Stößelspitze des ventilseitigen Stößels der Stößelvorrichtung positioniert ist, mittels der Stößelspitze in einem Ventilsitz des Ventils im stromlosen Ausgangszustand des Dosiersystems geschlossen ist.

Auch für die weitere Ausgestaltung der Stößelvorrichtung gibt es verschiedene Möglichkeiten.

Vorzugsweise kann das Übertragungselement der Stößelvorrichtung wiederum zwei miteinander koppelbare Teile umfassen. Diese können kraftschlüssig und/oder formschlüssig gekoppelt sein. Beispielsweise können die Teile miteinander verpresst sein.

Alternativ oder zusätzlich können die Teile miteinander verklebt sein.

Weiter bevorzugt können die Teile auch thermisch verschrumpft bzw. mittels thermischer Verschrumpfung gekoppelt sein.

Besonders bevorzugt kann weiter das Übertragungselement einen Stangenteil als einen Teil und einen Kopfhülsenteil als einen weiteren Teil aufweisen.

Dabei kann vorzugsweise ein länglicher, insbesondere zylindrischer, Stangenteil des Übertragungselements ventilseitig, d. h. an dem im eingebauten Zustand zum Ventil weisenden Ende, am Verschlusselement anstehen bzw. anliegen und sich von dort bis zu einem Kopfhülsenteil jenseits des Übersetzungshebels erstrecken. Beispielsweise kann der Stangenteil kippachsenfern am langen Hebelarm des Übersetzungshebels im Wesentlichen durch den Übersetzungshebel hindurch oder nebendran vorbei verlaufen.

Vorzugsweise kann sich der Stangenteil mit etwas umseitigen Spiel geführt durch eine Durchgangsöffnung bzw. Bohrung im Übersetzungshebel hindurch erstrecken.

Alternativ oder zusätzlich kann der Kopfhülsenteil vorzugsweise einen Flansch aufweisen, an dem ventilseitig, d. h. an der im eingebauten Zustand zum Ventil weisenden Flanschfläche, der Übersetzungshebel ansteht bzw. anliegt. Der Flansch kann sich besonders bevorzugt in etwa auf der Hälfte seiner Längserstreckung befinden.

Eine Aufteilung des Übertragungselements in mehrere für sich genommen wenig komplexe Einzelteile, die dann wiederum erst miteinander verbunden werden, macht deren Herstellung insgesamt günstiger und erleichtert diese zudem enorm. Wie bereits erwähnt können die Teile anschließend z. B. mittels thermischem Verpressen leicht zu einem gekoppelten Bauteil verbunden werden. Somit kann der Übersetzungshebel die Stößelvorrichtung sehr exakt geführt gegen die Kraft der beiden Verschlussfedern axial auslenken, in einem später noch erläuterten Ausführungsbeispiel also z. B. nach oben drücken, so dass sich das Ventil durch die Kraft der Öffnungsfeder aufgrund der vorübergehend überwundenen bzw. durch den Übersetzungshebel übernommenen Gegenkraft der Verschlussfedern automatisch öffnet bzw. in eine offene Ventilstellung begibt.

Auch für die Anordnung der Stößelvorrichtung im Gehäuse gibt es bevorzugte Möglichkeiten.

Vorzugsweise kann der Stangenteil des Übertragungselements ventilseitig parallel zum Piezo-Aktor in einem ersten Gehäusehülsen-Abschnitt einer Gehäusehülse des Gehäuses mit relativ engem radialen umseitigen Spiel axial geführt sein. Damit ist gemeint, dass der Stangenteil des Übertragungselements ventilseitig nahe des Übersetzungshebels, d. h. hier in einem Bereich knapp unterhalb des Übersetzungshebels auch noch leicht seitlich, in radialer Richtung bezogen auf die zylindrische Stange des Stangenteils in der Gehäusehülse bewegbar ist, jedoch grundsätzlich axial geführt sein kann. Somit bewegt sich der Stangenteil möglichst nur in axialer Richtung geradlinig, ohne nennenswerte Querbewegung aus dem Ventil aus dem Ventilsitz bzw. in das Ventil in einen Ventilsitz hinein.

Dahingegen kann der Kopfhülsenteil des Übertragungselements ventilabgewandt mit relativ weitem radialen umseitigen Spiel geführt sein. Dies erlaubt eine leichte Querbewegung bzw. Kreisbahnbewegung des Kopfhülsenteils, welche durch die kippachsenferne Kontaktstelle zum Übersetzungshebel entsteht, auf welchen wiederum wie bereits mehrfach erwähnt durch den Piezo-Aktor kippachsennah ein Impuls bzw. eine Art "Drehmoment" übertragen wird. Damit agiert der Kopfhülsenteil wie eine Art Pleuelstange, wie weiter unten noch genauer erläutert wird.

Mit anderen Worten kann der Kopfhülsenteil vom Ventil aus gesehen jenseits des Übersetzungshebels, also hier oberhalb in seiner radialen Bewegung fast gar nicht begrenzt sein, also nahezu frei eine volle Bewegungsbreite ausführen, d. h. zumindest insoweit er sich innerhalb der möglichen Bewegung des ventilseitig, also hier unten, relativ dazu eng axial geführten Stangenteils bewegen kann. Damit ist gemeint, dass er durch die Länge des Stangenteils sowieso auf eine sehr kleine Querbewegung bzw. Bewegungsbreite beschränkt ist. Denn wird der Kopfhülsenteil allzu weit seitlich bewegt, stößt der Stangenteil unten direkt an seiner engen umseitigen axialen Führung an und verhindert damit weitere Querbewegungen bzw. Querauslenkungen (bzw. radiale Bewegungen) des Kopfhülsenteils.

Vorzugsweise kann eine der Verschlussfedern, insbesondere z. B. diejenige kleine Druckschraubenfeder, die von der großen Druckschraubenfeder umgeben ist, der Federanordnung am Kopfhülsenteil auf einer ventilabgewandten Seite des Flansches des Kopfhülsenteils anstehen bzw. anliegen.

Damit lässt sich das Übertragungselement bzw. der Kopfhülsenteil des Übertragungselements ohne direkten Kontakt zum Hebel zwischen Gehäuse und Verschlusselement verspannen. Zudem spart diese Anordnung Platz, da diese Verschlussfeder im Inneren und somit ungenutzten Bereich der Vorspannfeder des Piezo-Hebel-Systems untergebracht ist und somit nicht unnötig die Stößelvorrichtung des Dosiersystems verlängert.

Vorzugsweise kann der Flansch des Kopfhülsenteils zur verschleißarmen Verzahnung zwischen Übersetzungshebel und Stößelvorrichtung ventilseitig im bestimmungsgemäß eingebauten Zustand auf der zum Ventil weisenden Seite halbkugelförmig hervorstehende Kugelschalen aufweisen. Sie können zusammen mit korrespondierenden Kugelkalotten, welche dazu am Übersetzungshebel ausgebildet, besonders bevorzugt ausgespart, sein können, ein Lager bilden.

Das Lager wird im Folgenden auch als Rolllager bezeichnet, da die Kugelschalen-Oberflächen in den Kugelkalotten eine leichte, besonders reibungsarme Rollbewegung durchführen, womit ein nahezu reibungsfreier Übergang zwischen der leichten Kreisbahn- bzw. Pleuelbewegung des Kopfhülsenteils und der Achsialbewegung des Stangenteils gebildet wird.

Besonders bevorzugt können die Kugelschalen im Flansch des Kopfhülsenteils in Form von halbkugelförmig ausgenommenen Kugelkalotten mit darin eingepressten Kugeln ausgebildet sein. Dies erleichtert die Herstellung, da das Ausbilden von halbkugelförmig vorstehenden Kugelschalen an einem der Bauteile entfallen kann.

Ganz besonders bevorzugt kann der Flansch des Kopfhülsenteils auf der Rückseite der Kontaktstelle, an der die obige Verschlussfeder ansteht, einen Lagerblock umfassen. Der Lagerblock kann z. B. wiederum in Form eines Quaders flanschartig (nach Art eines "blockförmigen Sehnenvierecks") am runden Flansch von der Verschlussfeder weg in Richtung zum Übersetzungshebel hin weiter vorstehen. Ein solcher zusätzlicher Lagerblock am runden Flansch hat den Vorteil, dass er Platz bietet, um darin die Kugelkalotten auszubilden bzw. auszusparen. Um die zwei Kugelkalotten-Ausnehmungen bzw. Kugelkalotten des Übersetzungshebels verschleißarm aufzunehmen, kann eine Lagerfläche des Lagerblocks wiederum in sich mit halbkugelförmig ausgesparten Kugelkalotten versehen sein, in denen wiederum Kugeln eingepresst sind, auf den die Kugelkalotten des Übersetzungshebels abrollen können.

Die "Verzahnung" über die in den Kopfhülsenteil eingepressten Kugeln zu den Kugelkalotten im Übersetzungshebel, die sich hierbei ergibt, wird nur im geschlossenen Zustand des Ventils "gelockert", wenn der Stößel bzw. das Verschlusselement durch einen Düsen- bzw. Ventileinsatz im Ventil etwas vom Übersetzungshebel abgehoben wird.

Auch für die weitere Ausgestaltung des Dosiersystems gibt es verschiedene Möglichkeiten.

Vorzugsweise kann an der Stößelvorrichtung, vorzugsweise am Kopfhülsenteil des Übertragungselements, ein erster Permanentmagnet befestigt sein. Der Permanentmagnet kann beispielsweise an einem ventilfernen, stirnseitigen Ende der Stößelvorrichtung befestigt sein.

Besonders bevorzugt kann der Permanentmagnet also genauer gesagt am Kopfhülsenteil der Stößelvorrichtung, an einem im bestimmungsgemäß eingebauten Zustand vom Übersetzungshebel abgewandten Ende der Stößelvorrichtung bzw. des Kopfhülsenteils der Stößelvorrichtung befestigt sein.

Dabei kann bevorzugt im Gehäuse gegenüberliegend durch einen Spalt beabstandet zu diesem Permanentmagneten ein Hall-Sensor angeordnet sein. Dieser kann praktischerweise z. B. auf einer Platine für die Steuerung etc. des Dosiersystems angeordnet sein, welche sich oberhalb des stirnseitigen Endes der Stößelvorrichtung, genauer gesagt des Kopfhülsenteils der Stößelvorrichtung befindet.

Mithilfe des Permanentmagneten und des Hall-Sensors lässt sich die Position der Stößelvorrichtung zum Ventil bzw. zur Düse messen und dann entsprechend einstellen. Dabei kann beispielsweise eine Normierungstabelle den Zusammenhang zwischen einer Spannungsänderung des Hall-Sensors und der zugrundeliegenden Distanzänderung aufzeigen. Zunächst liegt vor dem Einstellen der genauen Position der Stößelvorrichtung zur Düse der Kopfhülsenteil des Übertragungselements der Stößelvorrichtung am Übersetzungshebel an bzw. auf, wobei die Stößelspitze des Stößels die Düse bzw. das Ventil, ohne sie direkt zu berühren, in der normal geschlossenen Ventilstellung noch nicht verschließt. Zur Einstellung einer geeigneten Position des Stößels relativ zur Düse wird die Düse in Richtung Stößel verstellt, bis eine definierte Flussänderung mithilfe des Permanentmagneten und des Hall-Sensors detektiert wird und somit ein definiertes Abheben des Kopfhülsenteils, insbesondere der Kugelschalen aus den Kugelkalotten des Übersetzungshebels, vom Übersetzungshebel gegeben ist. Dazu wird der Abstand zwischen der Düse und der Stößelspitze durch Verdrehen einer Einstellmutter soweit reduziert, bis die gewünschte Spannungsänderung über den Hall-Sensor detektierbar ist. Diese gewünschte Position kann folglich im Betrieb auch kontinuierlich überwacht werden.

Genauer gesagt ist zu Beginn des Einstellvorganges bzw. "Adjustvorgangs" ein Abstand zwischen Düseneinsatz und Stößel zu schaffen, indem die später noch anhand eines Ausführungsbeispiels beschriebene Kopplungsmutter bzw. (Düsen-) Einstellmutter soweit verdreht wird, dass diese in der untersten einstellbaren Position steht (größter Abstand zwischen Düseneinsatz und Stößel). Dann wird die Einstellroutine bzw. "Adjustroutine" gestartet und der Abstand zunächst verkleinert und schließlich der Stößel durch den Düseneinsatz angehoben, bis eine Anzeige in der Steuereinheit anzeigt, dass die gewünschte Position (leichtes Abheben vom Hebel) erreicht ist.

Im Betrieb kann folglich immer kontrolliert werden, ob sich der Hebelbewegungsanteil, welcher ohne Mitnahme des Stößels (ein durch das leichte Abheben beim Einstellvorgang bzw. Adjustvorgang erzeugter Spalt) verändert und/oder ob sich die Spannung des Hall-Sensors im geschlossenen Zustand geändert hat und/oder wie groß die Gesamtänderung des Hall-Sensorsignals zur gewünschten bzw. erwarteten Stößelbewegung ist. Hier kann dann auch bei Bedarf das Ansteuersignal so angepasst werden, dass die Bewegung auch bei einem Verschleiß noch gleich und damit stabil bleibt. So kann ein notwendiges Eingreifen des Nutzers im Betrieb möglichst lange vermieden werden, was z. B. die Maschinenproduktivität steigert und Wartungszeiten reduziert.

Vorzugsweise kann auf einer vom ersten Permanentmagneten abgewandten Seite des Hall-Sensors ein zweiter, hier beispielsweise kleinerer, Permanentmagnet angeordnet sein.

Dabei kann vorzugsweise der zweite Permanentmagnet ein zum ersten Permanentmagneten entgegengesetztes Gegenmagnetfeld aufweisen.

Damit lässt sich der für Hall-Sensoren stets symmetrisch um den Nullpunkt aufgeteilte Messbereich des Hall-Sensors derart verschieben, dass ein größerer, vorteilhafterweise sein kompletter, Messbereich genutzt werden kann und er dadurch eine größere Sensitivität erhält. Denn der Hall-Sensor kann so nicht mehr nur noch im positiven oder im negativen Bereich messen. Vielmehr wird sein Messbereich zumindest teilweise, vorzugsweise komplett, in den negativen oder je nach Polung des Magnetfelds in den positiven Bereich verschoben und damit vergrößert.

Alternativ oder zusätzlich kann ein Umgebungsbereich um den Hall-Sensor, besonders bevorzugt inklusive des zweiten Permanentmagneten, zumindest auf den vom ersten Permanentmagneten abwandten Seiten mittels einer Abschirmung magnetisch abgeschirmt sein.

Mit den vom ersten Permanentmagneten abwandten Seiten ist gemeint, dass die Abschirmung vorteilhafterweise, zumindest einseitig zum ersten Permanentmagneten hin geöffnet sein kann, so dass der Kopfhülsenteil mit dem ersten Permanentmagneten zumindest auf dieser Seite in die Abschirmung hineingefahren werden kann und auf den übrigen Seiten äußere möglicherweise störende Magnetfeldeinflüsse abgeschirmt werden können. Hierfür kann die Abschirmung beispielsweise im Wesentlichen quaderförmig bzw. mit einem quaderförmigen Gehäuse ausgebildet sein.

Alternativ oder zusätzlich kann die Abschirmung auch aus einem quaderförmigen Bauteil, einem weichmagnetischen Hebellager und/oder einem in das Hebellager in Richtung Ventil eingelegten weichmagnetischen Bauteil bestehen. Ein weichmagnetisches Bauteil, welches in das Hebelager eingelegt wird, bietet speziell dann an, wenn das Hebellager aus einem günstigeren, stabilen Material, wie z. B. Aluminium etc. gefertigt ist, welches selbst nicht ausreichend magnetisch abschirmend wirkt, jedoch für die notwendige Stabilität sorgt.

Vorteilhafterweise können damit der obere Bereich oberhalb der oben bereits erwähnten Platine und der den Piezo-Aktor umschließende Rahmenbereich aus nicht magnetischen Werkstoffen gefertigt sein, um diese günstiger und leichter gestalten zu können. Allgemein können mit der Abschirmung praktischerweise Messfehler vermieden bzw. Störfaktoren, die Einfluss auf das gemessene Magnetfeld haben könnten, minimiert werden.

Vorzugsweise kann die oben bereits erwähnte Gehäusehülse, in der die Stößelvorrichtung zumindest abschnittsweise innenseitig geführt ist, außenseitig mittels einer Feder, die durch eine Mutter spannbar ist, relativ zum umgebenden Gehäuse des Dosiersystems zur Einstellung eines Abstands zwischen Ventil und Verschlusselement (typischerweise auch als "Düse-Stößel-Abstand" bezeichnet) in der Position verstellbar gelagert sein. Mit dieser Mutter lässt sich vom Kunden sehr einfach der Abstand verstellen und beispielsweise mittels der oben erwähnten Messung durch den Permanentmagneten und den Hall-Sensor z. B. im einfachsten Fall händisch auf einen sehr genauen Wert einstellen.

Vorzugsweise kann der Übersetzungshebel derart ausgebildet und angeordnet sein, dass in einer stromlosen Ausgangsstellung des Piezo-Aktors die Stößelvorrichtung so über den Übersetzungshebel gegen den Piezo-Aktor verspannt ist, dass eine kippachsennahe Aktorangriffsstelle des Piezo-Aktors am Übersetzungshebel auf einer Linie bzw. Ebene mit einer Rolllagerfläche der Welle der Kippachse zum Übersetzungshebel sowie den Kugelschalen am Flansch des Kopfhülsenteils in den kippachsenfernen Kugelkalotten am Übersetzungshebel liegt.

Dies hat den Vorteil, dass damit der Piezo-Aktor in der Ausgangsstellung auf einer Höhe der Kippachse und der Kontaktstelle zur Stößelvorrichtung am Übersetzungshebel angreift.

Zum Beispiel kann der Piezo-Aktor einerseits ortsfest starr über einen ventilseitigen Flächenkontakt abgestützt sein. Andererseits kann er hebelseitig kippachsennah am langen Hebelarm des Übersetzungshebels durch eine zum Flächenkontakt parallele linienförmige Aktorangriffsstelle verspannt sein.

Vorzugsweise kann das Verschlusselement, besonders bevorzugt zusammen mit der Fluidikeinheit, vorteilhafterweise direkt vom Kunden selbst lösbar, im Sinne von tauschbar, ganz besonders bevorzugt werkzeuglos lösbar, im Dosiersystem verbaut sein. Damit ist gemeint, dass das Verschlusselement zum Beispiel nur auf Druck mit dem Übertragungselement gekoppelt sein kann bzw. in Kontakt stehen kann, so dass es vom Kunden selbst sehr einfach und schnell, insbesondere werkzeuglos, wechselbar bzw. austauschbar ist. Das Verschlusselement derart wechselbar im Dosiersystem zu verbauen, ist deshalb besonders vorteilhaft, da so die Langlebigkeit des Dosiersystems insgesamt verbessert wird, da es das Bauteil des Dosiersystems ist, welches im Betrieb des Dosiersystems dem größten Verschleiß ausgesetzt ist.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich und lediglich als schematische Darstellung zu verstehen. Es zeigen:
Figur 1 einen Längsschnitt durch ein Ausführungsbeispiel eines erfindungsgemäßen Dosiersystems mit abgekoppelter Fluidikeinheit und demontiertem Stößel, mit Blick ins Innere eines teilweise geöffnet dargestellten Gehäuses,
Figur 2 eine perspektivische Seitenansicht auf das Ausführungsbeispiel aus Figur 1 mit den für die Dosiermechanik wesentlichsten Komponenten (wegen der Sichtbarkeit ohne Gehäuse), jedoch nun mit montiertem Stößel und angekoppelter Fluidikeinheit.

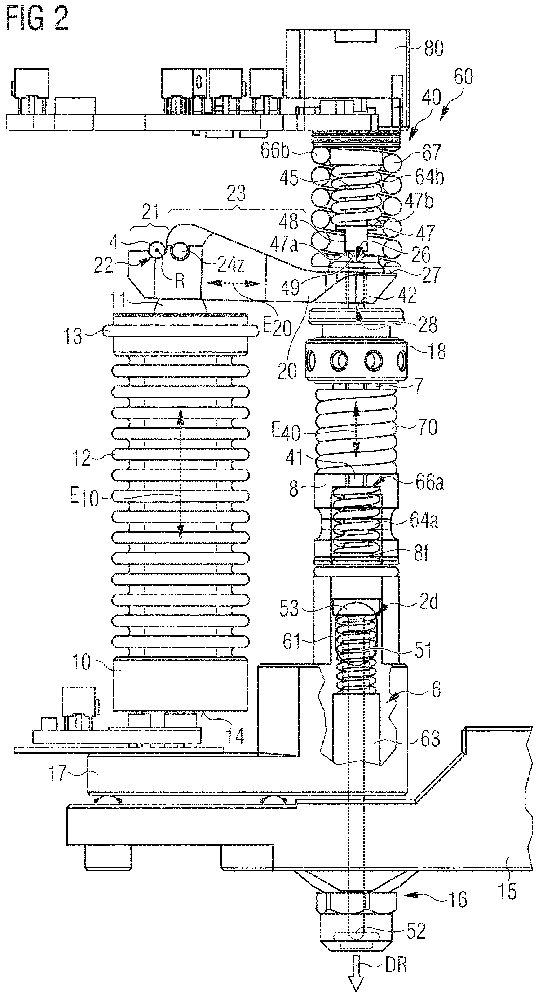

Die Figuren zeigen ein Ausführungsbeispiel eines erfindungsgemäßen Dosiersystems 1. Zu den Hauptkomponenten dieses Dosiersystems 1 gehört ein Gehäuse 2 mit einem darin befindlichen Piezo-Aktor 10, eine Fluidikeinheit 15 mit einem Ventil 16 (siehe Figur 2), eine Stößelvorrichtung 40 zum Verschließen des Ventils 16 und ein Übersetzungshebel 20 bzw. Hebel 20 zur Kopplung des Piezo-Aktors 10 mit der Stößelvorrichtung 40.

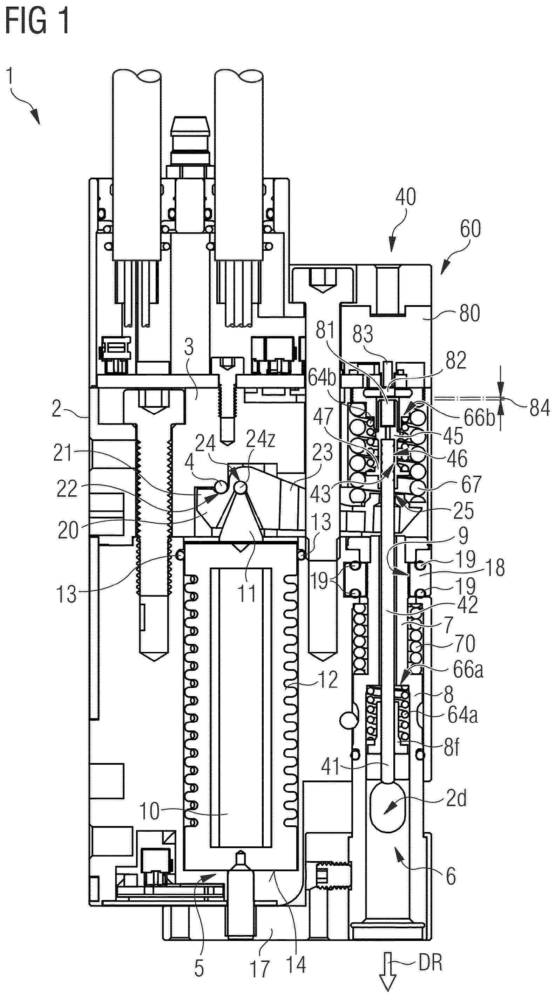

Im Großen und Ganzen lässt sich das Gehäuse 2 des Dosiersystems 1 im Wesentlichen als quaderförmig beschreiben. Figur 1 zeigt dabei einen Längsschnitt quer durch das Dosiersystem 1 mit abgekoppelter Fluidikeinheit (in Figur 1 nicht dargestellt). Figur 2 zeigt unter anderem wie und wo die Fluidikeinheit 15 des Dosiersystems 1 am übrigen Dosiersystem 1 gekoppelt ist.

Diesbezüglich weist das Gehäuse 2 im (hier rechten) unteren Eck auf der Unterseite eine Kopplungsstelle für ein längliches Verschlusselement 51 bzw. einen Stößel 51 der Stößelvorrichtung 40 sowie für die besagte Fluidikeinheit 15 mit dem Ventil 16 auf. Das Verschlusselement 51 bzw. der Stößel 51 ist dabei Teil der Fluidikeinheit 15 bzw. in diese verbaut und kann beim Wechsel der Fluidikeinheit 15 mit gewechselt werden.

In dem Ventil 16 sitzt dann, wie in Figur 2 zu sehen ist, im bestimmungsgemäß gekoppelten Zustand der Stößel 16 in einem sogenannten Ventilsitz bzw. Dichtsitz. In dieser Position verschließt er das Ventil 16 bedarfsgerecht, so dass kein Dosiermedium unbeabsichtigt aus dem Ventil 16 ausfließen bzw. austreten kann. An dieser Stelle sei noch einmal erwähnt, dass sich relative Richtungsangaben wie "oben", "unten", "oberhalb", "unterhalb", "oberseitig", "unterseitig", "seitlich bzw. links/rechts", "horizontal", "vertikal", "vorne", "hinten" etc. hierbei, wie auch in der gesamten Schrift, willkürlich auf die Darstellung in den Figuren beziehen, wenn gleich das Dosiersystem 1 im Betrieb typischerweise überwiegend in der in Figur 1 dargestellten Orientierung verwendet wird, d. h. meistens eine Dosierung auf ein Werkstück im Wesentlichen mit der Schwerkraft, also in Dosierrichtung DR, also z. B. in der Richtung vom Hebel 20 zum Ventil 16 nach unten erfolgt.

Auf der Oberseite im gegenüberliegenden, (hier linken) oberen Eck des Gehäuses 2 gehen mehrere Kabel bzw. Leitungen vom Gehäuse 2 ab. Über diese kann das Dosiersystem zur Steuerung, Stromversorgung etc. mit einer übergeordneten (hier nicht dargestellten) Steuereinheit und diese wiederum mit einer übergeordneten Dosieranlage verbunden werden.

Im Gehäuse 2 selbst befindet sich in der unteren Hälfte im Zentrum der zylindrisch eingekapselte Piezo-Aktor 10, wie später noch erläutert wird. Dieser ist unterseitig an seinem hinteren Ende auf einem ebenen Flächenkontakt 5 des Gehäuses 2 mit einer flächigen bzw. ebenen Auflagefläche 14 gelagert und über Durchkontaktierungsbohrungen elektrisch angeschlossen. Durch diese Lagerung können die Verluste im Lagerbereich minimiert werden. Am gegenüberliegenden, oberen Ende weist der Piezo-Aktor 10 eine trapezförmige zum darüberliegenden Hebel 20 zulaufende Aktor-Front 11 auf, die an einer im Hebel 20 versenkten Aktorangriffsstelle 24 im Inneren des Hebels 20 unter Bildung eines Rolllagers 24 an einem quer bzw. horizontal durch den Hebel 20 verlaufenden, Zylinderstift 24z ansteht bzw. angreift. Der Zylinderstift 24z ist hier fest in den Hebel 20 eingepresst, so dass der Piezo-Aktor 10 mit seiner Aktor-Front 11, welche an der Vorderseite maulartig bzw. konkav an die zylinderförmige Mantelfläche des Zylinderstifts 24z angepasst ist, auf dem Zylinderstift 24z leicht seitlich, also hier rechts bzw. links abrollen kann - wenn er wie vorgesehen zur Ausübung eines Impulses auf den Hebel 20 mittels Anlegen einer elektrischen Spannung in die Richtung nach oben gestreckt oder in die Gegenrichtung nach unten wieder zusammengestaucht wird.

Der Piezo-Aktor 10 selbst ist hier ein hermetisch gekapselter Piezo-Aktor 10, d. h. er umfasst einen Piezo-Stack, der abgesehen von durch die Kapselung 12 hindurchgeführten Leitungen von einer "wellenförmigen" Kapselung 12 des Piezo-Aktors 10 umgeben ist, die wiederum vom Gehäuse 2 mit etwas Spiel hohlzylinderförmig umschlossen ist. Ringförmig um die Oberseite des Piezo-Aktors 10 unterhalb der Aktor-Front 11 dichtet eine Ringdichtung 13 zwischen Kapselung 12 und Gehäuse 2 ab und bildet damit einen Zwischenraum um die Kapselung 12, in welchem zur Kühlung des Piezo-Aktors 10 im Betrieb um die Kapselung 12 herum eine Kühlflüssigkeit zirkulieren kann. Diese wird dazu vorteilhafterweise kühl kontinuierlich an einer Seite in den Zwischenraum eingeleitet und auf der gegenüberliegenden Seite warm wieder abgeführt (hier nicht dargestellt), so dass der Piezo-Aktor 10 eine gewisse maximale Betriebstemperatur jedenfalls nicht überschreitet.

Wie bereits erwähnt befindet sich oberhalb des Piezo-Aktors 10 der Hebel 20. Dieser ist über eine horizontal (hier in die Zeichenebene hinein bzw. hinaus) quer zum Hebel 20 verlaufende, zylindrische Welle 4, welche eine Kippachse R darstellt bzw. verkörpert, um die Welle 4 bzw. Kippachse R kippbar, im Gehäuse 2 gelagert.

Die Welle 4 ist dazu endseitig jeweils fix in einem Hebellager 3 bzw. Hebellagerteil des Gehäuses 2, welches Hebellager 3 den Hebel 20 umgibt, drehfest befestigt bzw. verankert. Der Hebel 20 wird durch eine Vorspannfeder 67 der Federanordnung 60 und den Piezo-Aktor 10 von unten gegen die Welle 4 gedrückt bzw. gespannt. In einer Ausgangsstellung ist er damit im Wesentlichen horizontal ausgerichtet.

Von der in einer Längserstreckung des Hebels 20 außermittigen bzw. dezentralen Position der Welle 4 bzw. Kippachse R erstreckt sich in eine Richtung (hier im Längsschnitt in Figur 1 nach links) ein sehr kurzer Hebelarm 21 und in die entgegengesetzte Richtung (hier nach rechts) ein im Verhältnis dazu langer Hebelarm 23. Der kurze Hebelarm 21 dient lediglich als Lager 22 bzw. Mulde für die Welle 4, so dass die außermittig positionierte Welle 4, welche sich sozusagen fast an einem Ende des Hebels 20 befindet, nicht zur Seite des kurzen Hebelarms 21 am Hebel 20 abrutschen kann.

Der lange Hebelarm 23 weist kippachsennah, also nahe der Position der Welle 4, die Aktorangriffsstelle 24 des Piezo-Aktors 10 auf und kippachsenfern, also an einem Endabschnitt des Hebelarms 23, eine Stößelkontaktstelle 25. An der Stößelkontaktstelle 25 kann der Hebel 20 die Stößelvorrichtung 40 - wie eine Art "Schaufel" mit einem "Loch" 28 bzw. einer Durchgangsöffnung 28 in der Schaufelfläche umseitig an der Innenkante des Lochs 28 - im Wesentlichen senkrecht zu seiner Erstreckungsrichtung E₂₀ aufnehmen bzw. anheben.

Die weiter oben bereits erwähnte Vorspannfeder 67, hier eine große Druckschraubenfeder 67 mit einem relativ zum Loch 28 größeren Innendurchmesser, steht zur Vorspannung des Hebels 20 gegen den Piezo-Aktor 10 um das Loch 28 herum entlang eines Lochrandes 27 des Lochs 28 bzw. an einem Vorspannfederkontaktstelle 27 oberseitig an der Schaufelfläche des Hebels 20 an.

Die dargestellte Anordnung ist besonders kompakt, da die Stößelvorrichtung 40 durch das Loch 28 des Hebels 20 hindurch (im Wesentlichen senkrecht zur Erstreckungsrichtung E₂₀ des Hebels 20) sehr nah am Piezo-Aktor 10 in einer Erstreckungsrichtung E₄₀ im Wesentlichen parallel zu einer Erstreckungsrichtung E₁₀ des Piezo-Aktors 10 im Gehäuse 2 verläuft. Mit anderen Worten sind also der Piezo-Aktor 10 und die Stößelvorrichtung 40 besonders kompakt nebeneinander vertikal im Gehäuse 2 im Wesentlichen in derselben Erstreckungsrichtung E₄₀, E₄₀ angeordnet und dabei über den relativ kurzen Hebel 20 miteinander verbunden und deshalb lediglich ein wenig voneinander beabstandet.

Die Stößelkontaktstelle 25, an der der Hebel 20 die Stößelvorrichtung 40 direkt (hier von unten bei einer Öffnungsbewegung des Ventils 16, wie weiter unten noch erläutert wird) schaufelartig untergreift und anhebt, weist eine Oberfläche mit zwei ausgesparten Kugelkalotten 26 auf, welche korrespondierende Kugelschalen 49 der Stößelvorrichtung 40 sozusagen verzahnt aufnehmen, wie ebenfalls weiter unten noch erläutert wird.

Die Stößelvorrichtung 40 selbst besteht hier aus zwei Stangenelementen 41, 51, die im betriebsbereiten Zustand des Dosiersystems 1 mittels der bereits erwähnten Federanordnung 60 gegeneinander verspannt sind. In diesem betriebsbereiten Zustand ist die Fluidikeinheit 15 mit dem Gehäuse 2 des Dosiersystems gekoppelt, wie dies in Figur 2 der Fall ist.

Das (hier obere) erste Stangenelement 41 bzw. Übertragungselement 41 der Stößelvorrichtung 40 besteht seinerseits aus zwei separat hergestellten Teilen 42, 45, nämlich einem länglichen Stangenteil 42 mit einer Stange mit zylindrischer Mantelfläche und einem länglichen Kopfhülsenteil 45 mit einem hohlzylindrischen Zylinderkörper und einem breiteren Kopf. Die beiden Teile 42, 45 werden für die Montage miteinander verpresst, d. h. der Stangenteil 42 wird dazu mit einem Endabschnitt innen im hohlzylindrischen Kopfhülsenteil 45 passgenau drehfest fixiert, z. B mittels thermischem Verschrumpfen.

Zur formschlüssigen Verbindung mit dem Kopfhülsenteil 45 weist die Stange des Stangenteils 42 auf der Mantelfläche im Bereich des Endabschnitts, welcher innen in den Kopfhülsenteil 45 eingeführt bzw. eingeschoben wird, radial nach außen vorstehende Ringnuten bzw. Rillen 43 auf.

Dazu korrespondierend weist der Kopfhülsenteil 45 des Übertragungselements 41 radial nach innen abstehende Ringfedern 46 auf, die im verbundenen Zustand der beide Teile 42, 45 zumindest leicht formschlüssig in die Ringnuten 43 bzw. Rillen 43 eingreifen. Bei den Ringnuten 43 und Ringfedern 46 der beiden Teile 42, 45 könnte es sich alternativ auch um korrespondierende Innen- und Außengewinde handeln, die sich ineinander verschrauben lassen, um die beiden Teile 42, 45 formschlüssig miteinander zu verbinden.

Der Kopf des Kopfhülsenteils 45 stellt einen relativ zum übrigen Kopfhülsenteil 45 breiteren Flansch 47 dar. Der Flansch 47 weist in axialer Richtung des Kopfhülsenteils 45 gesehen zwei unterschiedliche Oberflächen 47a, 47b auf. Ventilseitig (in axialer Richtung gesehen) umfasst er eine erste Flanschfläche 47a, welche durch einen quaderförmigen Lagerblock 48 gebildet wird. Ventilabgewandt weist er eine kreisscheibenförmige zweite Flanschfläche 47b auf.

An der ventilabgewandten runden Flanschfläche 47b steht eine der Verschlussfedern 64b bzw. kleineren Druckschraubenfedern 64b der Federanordnung 60 zum Verschließen des Ventils 16 an (welche weiter unten noch erläutert werden). Die Druckschraubenfeder 64b umschließt dabei ringförmig den innenliegenden Zylinderkörper des Kopfhülsenteils 45. Von der ventilabgewandten zweiten Flanschfläche 47b steht rückseitig, d. h. ventilseitig der besagte Lagerblock 48 flanschartig, hier in Form eines "Sehnenvierecks" bezüglich der kreisscheibenförmigen Flanschfläche 47b, hervor. Er weist die zwei (oben bereits erwähnten) in Richtung Hebel 20 halbkugelförmig vorstehenden Kugelschalen 49 auf. Diese rollen im Betrieb auf den (ebenso oben bereits erwähnten) korrespondierenden, im Hebel 20 an der Stößelkontaktstelle 25 ausgebildeten bzw. ausgesparten Kugelkalotten 26 ab. Damit ist der Kopfhülsenteil 45 der Stößelvorrichtung 40 mit dem Hebel 20 unter Bildung einer reibungsarmen Reibstelle quasi "verzahnt".

Das zweite (hier in Figur 2 untere) Stangenelement 51 bzw. Verschlusselement 51 der Stößelvorrichtung 40, im Folgenden auch kurz als Stößel 51 bezeichnet, ist einteilig. Es weist einen länglichen, zylindrischen Körper bzw. Schaft auf, welcher am unteren Ende - welches Ende im bestimmungsgemäß verbauten Zustand zum Ventil 16 weist - mit einer Stößelspitze 52 und am entgegengesetzten oberen Ende mit einem Stößelkopf 53 ausgebildet ist. Bei dem Stößelkopf 53 handelt es sich um einen Ringflansch, also um eine ringförmige Verbreiterung bzw. einen Kranz mit breiterem Außendurchmesser als am übrigen Körper bzw. Schaft des Stößels 51. Bei der Stößelspitze 52 handelt es sich hier beispielsweise um eine abgerundete Front des Stößels 51. Bei dem Stößel 51 könnte es sich beispielsweise, anders als hier dargestellt, allerdings auch um eine sogenannte "Ventilstößelstange" handeln, wie sie konkret in der Schrift DE 10 2020 121 777 beschrieben ist.

Oberseitig, d. h. hebelseitig des Stößels 51 steht am Stößelkopf 53 das oben bereits beschriebene Übertragungselement 41 an.

An dieser Stelle sei erwähnt, dass das Gehäuse 2, wie in Figur 1 gut zu erkennen ist, im Bereich bzw. in etwa auf Höhe des Stößelkopfes 53 des Stößels 51 eine hier leicht ovale Drainageöffnung 2d aufweist. Im Falle einer Leckage des zu dosierenden Dosiermediums sorgt diese dafür, dass das Dosiermedium aus der darunter befindlichen Düsenkammer der Fluidikeinheit 15 im Bereich der Stößelspitze 53 nicht in den oberhalb des Stößels 51 befindlichen Antriebsbereich des Dosiersystems 1 gelangt bzw. gedrückt werden kann, sondern davor bereits nach außen aus dem Dosiersystem 1 aus dieser Drainageöffnung 2d an einer vorteilhaft gewählten Stelle des Dosiersystems 1 ausfließen kann. Gleichzeitig ermöglicht die Größe der Drainageöffnung 2d eine leichte, also gut sichtbare optische Überprüfung dieses Bereiches.

Wie zum Teil bereits beschrieben ist die Stößelvorrichtung 40 mittels einer Federanordnung 60 federnd in sich gelagert bzw. gegeneinander verspannt. Die Federanordnung 60 weist dazu zum einen drei im Wesentlichen baugleiche, kleinere Druckschraubenfedern 61, 64a, 64b mit im Wesentlichen demselben Außendurchmessern auf, wobei die Druckschraubenfedern 64a, 64b eine Verschlussfederanordnung 64a, 64b darstellen und die Druckschraubenfeder 61 eine Öffnungsfederanordnung 61 darstellt.

Zwei der Druckschraubenfedern 64a, 64b bzw. Verschlussfedern 64a, 64b sind so angeordnet, dass ihre Federkraft die Stößelvorrichtung 40 in Richtung Ventil 16 drückt, um das Ventil 16 zu verschließen, indem sie letztlich den Stößel 51 der Stößelvorrichtung 40 in eine geschlossene Ventilstellung in den sogenannten Ventilsitz drücken.

Die untere Verschlussfeder 64a der beiden Verschlussfedern 64a, 64b ist dabei oberhalb des Stößelkopfes 53 des Stößels 51 innerhalb eines zweiten Gehäusehülsen-Abschnitts 8 einer Gehäusehülse 6 des Gehäuses 2 angeordnet und wirkt indirekt über eine Führungshülse 8f von oben auf den Stößelkopf 53 des Stößels 51. Dabei umschließt die Verschlussfeder 64a den Schaft bzw. zylindrischen Körper des Stangenteils 42 des Übertragungselements 41 mit etwas Spiel und ist oberseitig gegen eine Verengung 66a bzw. eine Kante 66a eines mit relativ engem umseitigen Spiel am Schaft des Stangenteils 42 enganliegenden ersten Gehäusehülsen-Abschnitts 7 der Gehäusehülse 6, in der die Stößelvorrichtung 40 gelagert ist, abgestützt.

Das Übertragungselement 41 wird zusätzlich durch die obere Verschlussfeder 64b der beiden Verschlussfedern 64a, 64b - die ja wie bereits beschrieben oberhalb eines Flansches 47 des Kopfhülsenteils 45 gelagert ist und sich gegen einen Teil 66b des Gehäuses 2 darüber abstützt - nach unten gegen das Verschlusselement 51 in Richtung Ventil 16 gedrückt.

Die dritte, übrige (kleinere) Druckschraubenfeder 61 bzw. Öffnungsfeder 61 ist direkt unterhalb des Stößelkopfes 53 des Stößels 51 angeordnet und drückt gegen den Stößelkopf 53, indem sie sich am unteren Ende gegen eine Führungshülse 63 abstützt, welche den Stößel 51 axial führt, wenn er wie in Figur 2 dargestellt, im Wesentlichen zusammen mit der Fluidikeinheit 15 und dem Ventil 16 mit dem übrigen Dosiersystem 1 gekoppelt wird.

In Summe drücken somit zwei Druckschraubenfedern 64a, 64b nach unten und eine Druckschraubenfeder 61 nach oben, so dass das Ventil 16 normalerweise, d. h. im stromlosen Zustand des Dosiersystems 1, allein durch das Kräfteungleichgewicht geschlossen ist.

Wenn der Hebel 20 im Betrieb dann durch einen Impuls des Piezo-Aktors 10 gegen den Kopfhülsenteil 45 drückt und diesen gegen den Druck der Verschlussfedern 64a, 64b der Federanordnung 60 zusammen mit dem Stangenteil 42 vom Ventil 16 wegbewegt, gibt er den darunter in einem verschließenden Ventilsitz befindlichen Stößel 51 ein Stück weit frei. Dadurch, dass dabei die Federkraft der Verschlussfedern 64a, 64b durch den Hebel 20 übernommen wird, wirkt der Öffnungsfeder 61 temporär keine oder zumindest eine geringere Federkraft entgegen, so dass die Öffnungsfeder 61 den Stößel 51 aus dem Ventilsitz nach oben in eine geöffnete Ventilstellung drücken kann.

Zusätzlich zur Federanordnung 60 weist das Dosiersystem 1 noch eine Kopplungsfeder 70 auf. Diese dient der manuellen Einstellmöglichkeit des Düse-Stößel-Abstands durch den Kunden, wenn z. B: die Fluidikeinheit 15 mit dem gewünschten Ventil 16 sowie mit dem passenden Stößel 51 (welcher wie gesagt Teil der Fluidikeinheit 15 sein kann) am übrigen Dosiersystem 1 montiert werden. Dazu umfasst das Dosiersystem 1 eine Kopplungsmutter 18 an der Fluidikeinheit 15, die sich auf ein Gewinde 9 an der Fluidikeinheit 15 bzw. Gehäusehülse 6 des Gehäuses 2 schrauben lässt, um die Fluidikeinheit 15 mit dem übrigen Dosiersystem 1 zu koppeln. Die Kopplungsmutter 18 kann dabei gegen die Federkraft der Kopplungsfeder 70 angezogen und damit der Düse-Stößel-Abstand genauer eingestellt werden. Die Kopplungsfeder 70 weist dazu einen Innendurchmesser auf, der größer ist als der Außendurchmesser des ersten Gehäusehülsen-Abschnitts 7, aber kleiner, insbesondere in etwa genauso groß, wie der Außendurchmesser des zweiten Gehäusehülsen-Abschnitts 8. Die Kopplungsfeder 70 liegt auf einer Oberseite des zweiten Gehäusehülsen-Abschnitts 8 auf und steht oben an der Kopplungsmutter 18 an. Somit umschließt sie passend den ersten Gehäusehülsen-Abschnitt 7 und stützt sich am zweiten Gehäusehülsen-Abschnitt 8 nach unten hin in Richtung Ventil 15 ab. Damit an der Kopplungsstelle der Kopplungsmutter 18 oberhalb der Kopplungsfeder 70 keine Flüssigkeit, wie z. B. Dosiermedium in den Gehäuseteil, also unter anderem den Piezo-Aktor umgebenden bzw. aufnehmenden Rahmen darüber eindringen kann, ist diese mittels zweier Ringdichtungen 19 oberhalb und unterhalb doppelt abgedichtet.

Des Weiteren umfasst das Dosiersystem 1 auch noch eine Fluidikpositionierung 17 zur Positionierung der Fluidikeinheit 15, welche Fluidikpositionierung 17 mit einer entsprechenden Regelung wahlweise beheizbar ist. Diese dient dazu das Dosiermedium, die Fluidikeinheit 15 mit dem Ventil 16 und/oder den Stößel 51 im Ventil 16 zu heizen.

Am entgegengesetzten oberen Ende des Gehäuses 2 des Dosiersystems 1 oberhalb der mit der Federanordnung 60 gegeneinander verspannten Stößelvorrichtung 40 befindet sich eine magnetische Abschirmung 80 als Teil des Gehäuses 2. Die magnetische Abschirmung 80 schirmt eine Hall-Sensor-Anordnung mit einem ersten Permanentmagneten 81, einem durch einen Spalt 84 davon beabstandeten Hall-Sensor 82 und einen zweiten Permanentmagneten 83 oberhalb des ersten Permanentmagneten 81 magnetisch nach außen, insbesondere nach oben hin, ab.

Ein Teil des Gehäuses 2 im Bereich des Hebellagers 3 dient als weitere magnetische Abschirmung unterhalb der magnetischen Abschirmung 80, um die Hallsensor-Anordnung auch nach unten magnetisch abzuschirmen. Insgesamt ist so die Hallsensor-Anordnung gegen äußere Einflüsse geschützt, so dass der Hall-Sensor ungestört möglichst genau messen kann. Denn die Hall-Sensor-Anordnung dient dazu, den Stößel-Düsen-Abstand sehr genau einstellen und im Betrieb auch als eine Art "Feedback-System" überwachen zu können. So kann beispielsweise im Betrieb die Bewegung des Stößels mit der Ansteuerspannung in Korrelation gebracht und gegebenenfalls die Ansteuerspannung nachgeregelt werden oder aber eine Warnmeldung kann erzeugt werden, wenn der gemessene Wert sich außerhalb eines zuvor definierten Sollbereiches befindet und etwa der Eingriff eines Bedieners erforderlich wird. Dies wird erreicht, indem ein Abstand des ersten Permanentmagneten 81, der als kleiner stabförmiger Permanentmagnet 81 in das obere Hülsenende des Kopfhülsenteils 45 eingesteckt ist, zum Hall-Sensor 82 vom Hall-Sensor 82 in Form einer absoluten Magnetfeldmessung detektiert wird. Wird ein definierter Wert gemessen, liegt ein idealer gewünschter Abstand bzw. Spalt 84 vor. Entsprechend befindet sich dann auch der Stößel 51 am anderen Ende der Stößelvorrichtung 40 in einer gewünschten Position, also einem gewünschten Stößel-Düsen-Abstand zum Ventil 16 bzw. zur Düse 16. Der zweite Permanentmagnet 83, der oberhalb des Hall-Sensors 82 auf einer vom ersten Permanentmagneten 81 abgewandten Seite des Hall-Sensors 82 befestigt und so angeordnet ist, dass sein Magnetfeld entgegen dem Magnetfeld des ersten Permanentmagneten wirkt, dient dabei dazu das Magnetfeld derart zu verschieben, dass der Messbereich des Hall-Sensors 82 vollständig ausgenutzt werden kann. Damit ist gemeint, dass der Messbereich des Hall-Sensors 82, welcher normalerweise auf einen positiven und einen negativen Bereich aufgeteilt ist, möglichst vollständig in den positiven oder in den negativen Bereich verschoben wird, um somit die Sensitivität des Hall-Sensors 82 zu erhöhen.

Es wird abschließend noch einmal darauf hingewiesen, dass es sich bei der vorhergehend detailliert beschriebenen Vorrichtung lediglich um ein Ausführungsbeispiel handelt, welches vom Fachmann in verschiedenster Weise modifiziert werden kann, ohne den Bereich der Erfindung zu verlassen. Beispielsweise könnten auch mehrere Dosiersysteme in einer Dosieranlage angeordnet sein. Weiterhin schließt die Verwendung der unbestimmten Artikel "ein" bzw. "eine" nicht aus, dass die betreffenden Merkmale auch mehrfach vorhanden sein können.

### Bezugszeichenliste

1 Dosiersystem
2 Gehäuse
2d Drainageöffnung
3 Hebellager des Gehäuses
4 Welle
5 Flächenkontakt des Gehäuses für den Piezo-Aktor
6 Gehäusehülse
7 erster Gehäusehülsen-Abschnitt
8 zweiter Gehäusehülsen-Abschnitt
8f Führungshülse im zweiten Gehäusehülsen-Abschnitt zur Führung der Verschlussfeder
9 Gewinde
10 Piezo-Aktor
11 Piezo-Aktor-Front
12 Kapselung
13 Ringdichtung
14 Auflagefläche
15 Fluidikeinheit
16 Ventil / Düse
17 Fluidikpositionierung
18 Kopplungsmutter der Fluidikeinheit
19 Ringdichtungen für die Kopplungsmutter
20 Übersetzungshebel / Hebel
21 kurzer Hebelarm
22 Lager für Welle
23 langer Hebelarm
24 Aktorangriffsstelle / Rolllager, kippachsennah
24z Zylinderstift der Aktorangriffsstelle
25 Stößelkontaktstelle, kippachsenfern
26 Kugelkalotten
27 Vorspannfederkontaktstelle / tellerförmiger Teil des Übersetzungshebels
28 Loch / Durchgangsöffnung des Übersetzungshebels für den Stangenteil
40 Stößelvorrichtung
41 erstes Stangenelement / Übertragungselement
42 Stangenteil des Übertragungselements
43 Ringnuten des Stangenteils
45 Kopfhülsenteil des Übertragungselements
46 Ringfedern des Kopfhülsenteils
47 Flansch des Kopfhülsenteils
47a erste Flanschfläche, ventilseitig
47b zweite Flanschfläche
48 Lagerblock
49 Kugelschalen
51 zweites Stangenelement / Verschlusselement / Stößel
52 Stößelspitze des Stößels / Verschlusselements der Stößelvorrichtung
53 Stößelkopf
60 Federanordnung
61 Öffnungsfederanordnung / Öffnungsfeder / Druckschraubenfeder
63 Führungshülse für das Verschlusselement
64a, b Verschlussfederanordnung / Verschlussfedern / Druckschraubenfedern
66a Verengung / Kante des Gehäuses
66b Teil des Gehäuses
67 Vorspannfeder / Druckschraubenfeder
70 Kopplungsfeder
80 Abschirmung
81 erster Permanentmagnet
82 Hall-Sensor / Hall-Sonde
83 zweiter Permanentmagnet
84 Spalt
DR Dosierrichtung / Richtung vom Übersetzungshebel zum Ventil
E₁₀ Erstreckungsrichtung des Piezo-Aktors
E₂₀ Erstreckungsrichtung / Hebelarm-Längsrichtung des Übersetzungshebels
E₄₀ Erstreckungsrichtung der Stößelvorrichtung
R Kippachse durch die Welle

## Patentansprüche

1. Dosiersystem (1) mit
- einem Gehäuse (2),
- einem darin befindlichen Piezo-Aktor (10),
- einer Fluidikeinheit (15) mit einem Ventil (16),
- einer Stößelvorrichtung (40) zum Verschließen des Ventils (16)
- und einem Übersetzungshebel (20) zur Kopplung des Piezo-Aktors (10) mit der Stößelvorrichtung (40),
wobei der Piezo-Aktor (10) im Wesentlichen parallel neben der Stößelvorrichtung (40) im Gehäuse (2) angeordnet ist, wobei sich der Piezo-Aktor (10) im Wesentlichen in Richtung einer zum Ventil (16) weisenden Seite vom Übersetzungshebel (20) weg erstreckt,
wobei der Piezo-Aktor (10) über den Übersetzungshebel (20) mit der Stößelvorrichtung (40) mittels einer Federanordnung (60) relativ zum Gehäuse (2) verspannt ist,
**dadurch gekennzeichnet,**
**dass** die Federanordnung (60) zur gefederten Verspannung der Stößelvorrichtung (40) mehrere Federn (61, 64a, 64b, 67) aufweist.

2. Dosiersystem nach Anspruch 1, wobei sich der Übersetzungshebel (20) quer zu einer Erstreckungsrichtung (E₁₀) des Piezo-Aktors (10) und einer Erstreckungsrichtung (E₄₀) der Stößelvorrichtung (40) erstreckt.

3. Dosiersystem nach Anspruch 1 oder 2, wobei die Stößelvorrichtung (40) aus zumindest zwei Stangenelementen (41, 51) ausgebildet ist, die gegeneinander verspannt sind, wobei vorzugsweise die Stößelvorrichtung (40) hebelseitig ein Übertragungselement (41) als ein erstes Stangenelement (41) und ventilseitig ein Verschlusselement (51) als ein zweites Stangenelement (51) aufweist.

4. Dosiersystem nach einem der vorstehenden Ansprüche, wobei die Federanordnung (60) zur gefederten Verspannung der Stößelvorrichtung (40) mehrere Druckschraubenfedern (61, 64a, 64b, 67) aufweist, und/oder
eine Öffnungsfederanordnung (61) zum Öffnen des Ventils (16) und eine Verschlussfederanordnung (64a, 64b), welche relativ zur Öffnungsfederanordnung (61) eine größere Federrate und/oder Vorspannkraft aufweist, besonders bevorzugt zumindest zwei gleichläufig, aber gegenläufig zur Öffnungsfederanordnung (61) arbeitende Verschlussfedern (64a, 64b), zum Schließen des Ventils (16).

5. Dosiersystem nach Anspruch 4, wobei die Öffnungsfederanordnung (61) das Verschlusselement (51) derart federnd im Gehäuse (2) einspannt, dass auf das Verschlusselement (51) eine Kraft wirkt, um das Verschlusselement (51) in Richtung einer geöffneten Ventilstellung zu verbringen,
und wobei die Verschlussfederanordnung (64a, 64b) das Übertragungselement (41) derart federnd im Gehäuse (2) verspannt, dass auf das Übertragungselement (41) eine gegenläufige Kraft wirkt, um das Übertragungselement (41) gegen das Verschlusselement (51) und damit das Verschlusselement (51) in Richtung einer geschlossenen Ventilstellung zu verbringen.

6. Dosiersystem nach einem der Ansprüche 3 bis 5, wobei das Übertragungselement (41) zwei miteinander koppelbare Teile (42, 45), vorzugsweise einen Stangenteil (42) und einen Kopfhülsenteil (45), aufweist,
wobei vorzugsweise ein länglicher Stangenteil (42) des Übertragungselements (41) ventilseitig am Verschlusselement (51) ansteht und sich von dort, vorzugsweise durch eine Durchgangsöffnung (28) im Übersetzungshebel (20), bis zu einem Kopfhülsenteil (45) jenseits des Übersetzungshebels (20) erstreckt,
und/oder
wobei vorzugsweise der Kopfhülsenteil (45) einen Flansch (47) aufweist, an dem ventilseitig der Übersetzungshebel (20) ansteht.

7. Dosiersystem nach Anspruch 6, wobei der Stangenteil (42) des Übertragungselements (41) ventilseitig parallel zum Piezo-Aktor (10) in einem ersten Gehäusehülsen-Abschnitt (7) einer Gehäusehülse (6) des Gehäuses (2) mit relativ engem radialen umseitigen Spiel axial geführt ist,
wohingegen der Kopfhülsenteil (45) des Übertragungselements (41) ventilabgewandt mit relativ weitem radialen umseitigen Spiel geführt ist.

8. Dosiersystem nach Anspruch 6 oder 7, wobei eine der Verschlussfedern (64b) der Federanordnung (60) am Kopfhülsenteil (45) auf einer ventilabgewandten Flanschfläche (47b) des Flansches (47) ansteht.

9. Dosiersystem nach einem der Ansprüche 6 bis 8, wobei der Flansch (47) des Kopfhülsenteils (45) ventilseitig halbkugelförmig hervorstehende Kugelschalen (49) aufweist, welche zusammen mit korrespondierenden Kugelkalotten (26), die dazu am Übersetzungshebel (20) ausgebildet, vorzugsweise ausgespart, sind, ein Lager (26, 49) bilden.

10. Dosiersystem nach einem der vorstehenden Ansprüche, wobei an der Stößelvorrichtung (40), vorzugsweise am Kopfhülsenteil (45) des Übertragungselements (41), ein erster Permanentmagnet (81) befestigt ist
und wobei im Gehäuse (2) gegenüberliegend durch einen Spalt (84) beabstandet zu diesem Permanentmagneten (81) ein Hall-Sensor (82) angeordnet ist.

11. Dosiersystem nach Anspruch 10, wobei auf einer vom ersten Permanentmagneten (81) abgewandten Seite des Hall-Sensors (82) ein zweiter Permanentmagnet (83) angeordnet ist, wobei der zweite Permanentmagnet (83) ein zum ersten Permanentmagneten (81) entgegengesetztes Gegenmagnetfeld aufweist
und/oder
wobei ein Umgebungsbereich um den Hall-Sensor (82), vorzugsweise inklusive des zweiten Permanentmagneten (83), zumindest auf den vom ersten Permanentmagneten (81) abwandten Seiten mittels einer Abschirmung (80) magnetisch abgeschirmt ist.

12. Dosiersystem nach einem der Ansprüche 7 bis 11, wobei eine Gehäusehülse (6) relativ zum umgebenden Gehäuse (2) des Dosiersystems (1) zur Einstellung eines Abstands zwischen Ventil (16) und Verschlusselement (51) in der Position verstellbar gelagert ist.

13. Dosiersystem nach einem der vorstehenden Ansprüche, wobei der Übersetzungshebel (20) kippbar an einer Kippachse (R) in Form einer Welle (4) an einer zum Piezo-Aktor (10) weisenden Seite eingespannt ist, welche Welle (4) wiederum jeweils endseitig in einem Hebellager (3) befestigt ist,
wobei der Piezo-Aktor (10) zum Öffnen des Ventils (16) kippachsennah an einer Aktorangriffsstelle (24) im rechten Winkel zur Kippachse (R) am Übersetzungshebel (20) unter Bildung eines Rolllagers ansteht.

14. Dosiersystem nach Anspruch 13, wobei der Übersetzungshebel (20) derart ausgebildet und angeordnet ist, dass in einer stromlosen Ausgangsstellung des Piezo-Aktors (10) die Stößelvorrichtung (40) so über den Übersetzungshebel (20) gegen den Piezo-Aktor (10) verspannt ist, dass eine Aktorangriffsstelle (24) des Piezo-Aktors (10) am Übersetzungshebel (20) auf einer Linie mit einer Rolllagerfläche der Welle (4) der Kippachse (R) zum Übersetzungshebel (20) sowie den Kugelschalen (49) am Flansch (47) des Kopfhülsenteils (45) in den Kugelkalotten (26) am Übersetzungshebel (20) liegt.

15. Dosiersystem nach einem der Ansprüche 3 bis 14, wobei das Verschlusselement (51), vorzugsweise zusammen mit der Fluidikeinheit (15), lösbar im Dosiersystem (1) verbaut ist.

## Claims

1. A metering system (1) with
- a housing (2),
- a piezo actuator (10) located therein,
- a fluidic unit (15) with a valve (16),
- a plunger device (40) for closing the valve (16)
- and a transmission lever (20) for coupling the piezo actuator (10) to the plunger device (40),
wherein the piezo actuator (10) is arranged substantially parallel next to the plunger device (40) in the housing (2), wherein the piezo actuator (10) extends away from the transmission lever (20) substantially in the direction of a side facing the valve (16), wherein the piezo actuator (10) is tensioned relative to the housing (2) via the transmission lever (20) with the plunger device (40) by means of a spring arrangement (60),
**characterised in that** the spring arrangement (60) comprises several springs (61, 64a, 64b, 67) for the sprung tensioning of the plunger device (40).

2. The metering system according to Claim 1, wherein the transmission lever (20) extends transversely to an extent direction (E₁₀) of the piezo actuator (10) and an extent direction (E₄₀) of the plunger device (40).

3. The metering system according to Claim 1 or 2, wherein the plunger device (40) is formed from at least two rod elements (41, 51), which are tensioned with respect to one another, wherein preferably the plunger device (40) comprises on the lever side a transmission element (41) as a first rod element (41), and on the lever side a closure element (51) as a second rod element (51).

4. The metering system according to one of the preceding claims, wherein the spring arrangement (60) has several compression coil springs (61, 64a, 64b, 67) for the sprung tensioning of the plunger device (40), and/or
an opening spring arrangement (61) for opening the valve (16) and a closure spring arrangement (64a, 64b), which has a greater spring rate and/or pretensioning force relative to the opening spring arrangement (61), particularly preferably at least two closure springs (64a, 64b) operating in the same direction, but contrary to the opening spring arrangement (61), for closing the valve (16).

5. The metering system according to Claim 4, wherein the opening spring arrangement (61) fits the closure element (51) resiliently in the housing (2) such that a force acts on the closure element (51), in order to bring the closure element (51) in the direction of an opened valve position,
and wherein the closure spring arrangement (64a, 64b) tensions the transmission element (41) resiliently in the housing (2) such that a contrary force acts on the transmission element (41), in order to bring the transmission element (41) against the closure element (51) and thus to bring the closure element (51) in the direction of a closed valve position.

6. The metering system according to one of Claims 3 to 5, wherein the transmission element (41) has two parts (42, 45) which are able to be coupled to one another, preferably a rod part (42) and a head sleeve part (45),
wherein preferably an elongated rod part (42) of the transmission element (41) stands on the valve side at the closure element (51) and extends from there, preferably through a through-opening (28) in the transmission lever (20), up to a head sleeve part (45) on the other side of the transmission lever (20),
and/or
wherein preferably the head sleeve part (45) has a flange (47), at which the transmission lever (20) stands on the valve side.

7. The metering system according to Claim 6, wherein the rod part (42) of the transmission element (41) is guided axially on the valve side parallel to the piezo actuator (10) in a first housing sleeve portion (7) of a housing sleeve (6) of the housing (2) with relatively close radial surrounding play,
whereas the head sleeve part (45) of the transmission element (41) facing away from the valve is guided with relatively wide radial surrounding play.

8. The metering system according to Claim 6 or 7, wherein one of the closure springs (64b) of the spring arrangement (60) stands at the head sleeve part (45) on a flange surface (47b) of the flange (47) facing away from the valve.

9. The metering system according to one of Claims 6 to 8, wherein the flange (47) of the head sleeve part (45) has spherical shells (49) protruding in a hemispherical manner on the valve side, which form a bearing (26, 49) together with corresponding spherical caps (26), which are formed, preferably recessed, for this on the transmission lever (20).

10. The metering system according to one of the preceding claims, wherein a first permanent magnet (81) is fastened on the plunger device (40), preferably on the head sleeve part (45) of the transmission element (41)
and wherein in the housing (2) a Hall sensor (82) is arranged lying opposite, spaced apart by a gap (84) with respect to this permanent magnet (81).

11. The metering system according to Claim 10, wherein on a side of the Hall sensor (82) facing away from the first permanent magnet (81) a second permanent magnet (83) is arranged, wherein the second permanent magnet (83) has a counter magnetic field opposed to the first permanent magnet (81)
and/or
wherein a surrounding region around the Hall sensor (82), preferably including the second permanent magnet (83), is magnetically shielded at least on the sides facing away from the first permanent magnet (81) by means of a shield (80).

12. The metering system according to one of Claims 7 to 11, wherein a housing sleeve (6) is mounted adjustably in position relative to the surrounding housing (2) of the metering system (1) for adjusting a distance between valve (16) and closure element (51).

13. The metering system according to one of the preceding claims, wherein the transmission lever (20) is fitted in a tiltable manner on a tilting axis (R) in the form of a shaft (4) on a side facing the piezo actuator (10), which shaft (4) in turn is respectively fastened at the end side in a lever bearing (3),
wherein the piezo actuator (10) for opening the valve (16) stands close to the tilting axis at an actuator engagement point (24) at right angles to the tilting axis (R) at the transmission lever (20) with the formation of a roller bearing.

14. The metering system according to Claim 13, wherein the transmission lever (20) is configured and arranged such that in a currentless starting position of the piezo actuator (10) the plunger device (40) is tensioned via the transmission lever (20) against the piezo actuator (10) so that an actuator engagement point (24) of the piezo actuator (10) at the transmission lever (20) lies on a line with a roller bearing surface of the shaft (4) of the tilting axis (R) to the transmission lever (20) and the spherical shells (49) at the flange (47) of the head sleeve part (45) in the spherical caps (26) at the transmission lever (20).

15. The metering system according to one of Claims 3 to 14, wherein the closure element (51), preferably together with the fluidic unit (15), is installed detachably in the metering system (1).

## Revendications

1. Système de dosage (1) avec
- un boîtier (2),
- un actionneur piézoélectrique (10) intégré,
- une unité fluidique (15) avec une soupape (16),
- un dispositif à poussoir (40) pour fermer la soupape (16)
- et un levier de transmission (20) pour coupler l'actionneur piézoélectrique (10) au dispositif à poussoir (40),
l'actionneur piézoélectrique (10) étant disposé dans le boîtier (2) essentiellement parallèlement à côté du dispositif à poussoir (40), l'actionneur piézoélectrique (10) s'étendant essentiellement dans la direction d'un côté du levier de transmission (20) tourné vers la soupape (16),
l'actionneur piézoélectrique (10) étant tendu par rapport au boîtier (2) via le levier de transmission (20) avec le dispositif à poussoir (40) au moyen d'un dispositif à ressort (60), **caractérisé en ce**
**que** le dispositif à ressort (60) comporte plusieurs ressorts (61, 64a, 64b, 67) pour la tension élastique du dispositif à poussoir (40).

2. Système de dosage selon la revendication 1, dans lequel le levier de transmission (20) s'étend transversalement par rapport à une direction d'extension (E₁₀) de l'actionneur piézoélectrique (10) et à une direction d'extension (E₄₀) du dispositif à poussoir (40).

3. Système de dosage selon la revendication 1 ou 2, dans lequel le dispositif à poussoir (40) est formé d'au moins deux éléments de tige (41, 51) qui sont serrés l'un contre l'autre, le dispositif à poussoir (40) comportant de préférence, côté levier, un élément de transmission (41) en tant que premier élément de tige (41) et, côté soupape, un élément de fermeture (51) en tant que deuxième élément de tige (51).

4. Système de dosage selon l'une des revendications précédentes, dans lequel le dispositif à ressort (60) destiné à la tension élastique du dispositif à poussoir (40) comprend plusieurs ressorts hélicoïdaux de pression (61, 64a, 64b, 67) et/ou
un dispositif à ressort d'ouverture (61) pour ouvrir la soupape (16) et un dispositif à ressort de fermeture (64a, 64b) qui présente une raideur et/ou une force de précontrainte supérieure à celle du dispositif à ressort d'ouverture (61), de préférence au moins deux ressorts de fermeture (64a, 64b) fonctionnant dans le même sens mais en opposition au dispositif à ressort d'ouverture (61), pour fermer la soupape (16).

5. Système de dosage selon la revendication 4, dans lequel le dispositif à ressort d'ouverture (61) serre l'élément de fermeture (51) de manière élastique dans le boîtier (2) de telle sorte qu'une force agit sur l'élément de fermeture (51) afin de déplacer l'élément de fermeture (51) vers une position de soupape ouverte,
et dans lequel le dispositif à ressort de fermeture (64a, 64b) serre l'élément de transmission (41) de manière élastique dans le boîtier (2) de telle sorte qu'une force opposée s'exerce sur l'élément de transmission (41) afin de déplacer l'élément de transmission (41) contre l'élément de fermeture (51) et ainsi l'élément de fermeture (51) dans la directiond'une position de soupape fermée.

6. Système de dosage selon l'une des revendications 3 à 5, dans lequel l'élément de transmission (41) comporte deux parties (42, 45) pouvant être couplées l'une à l'autre, de préférence une partie tige (42) et une partie de douille de tête (45),
une partie tige allongée (42) de l'élément de transmission (41) étant de préférence en contact avec l'élement de fermeture (51) côté soupape et s'étendant de là, de préférence à travers une ouverture de passage (28) dans le levier de transmission (20), jusqu'à une partie formant une partie de douille de tête (45) située au-delà du levier de transmission (20),
et/ou
la partie de douille de tête (45) comportant de préférence une bride (47) sur laquelle le levier de transmission (20) est fixé côté soupape.

7. Système de dosage selon la revendication 6, dans lequel la partie tige (42) de l'élément de transmission (41) est guidée axialement du côté de la soupape parallèlement à l'actionneur piézoélectrique (10) dans une première section de douille de boîtier (7) d'une douille de boîtier (6) du boîtier (2) avec un jeu radial relativement étroit de l'autre côté, tandis que la partie de douille de tête (45) de l'élément de transmission (41) est guidée à l'opposé de la soupape avec un jeu radial relativement large de l'autre côté.

8. Système de dosage selon la revendication 6 ou 7, dans lequel l'un des ressorts de fermeture (64b) du dispositif à ressort (60) est en appui sur la partie de douille de tête (45) sur une surface de bride (47b) de la bride (47) opposée à la soupape.

9. Système de dosage selon l'une des revendications 6 à 8, dans lequel la bride (47) de la partie de douille de tête (45) comporte, du côté de la soupape, des coques sphériques (49) saillantes hémisphériques qui, conjointement avec des calottes sphériques correspondantes (26), qui sont formées au levier de transmission (20), de préférence évidées, , forment un palier (26, 49).

10. Système de dosage selon l'une des revendications précédentes, dans lequel un premier aimant permanent (81) est fixé au dispositif à poussoir (40), de préférence à la partie douille de tête (45) de l'élément de transmission (41)
et dans lequel un capteur à effet Hall (82) est disposé dans le boîtier (2) en face de cet aimant permanent (81), à distance de celui-ci par une fente (84).

11. Système de dosage selon la revendication 10, dans lequel un deuxième aimant permanent (83) est disposé sur un côté du capteur à effet Hall (82) opposé au premier aimant permanent (81), le deuxième aimant permanent (83) présentant un champ magnétique opposé à celui du premier aimant permanent (81)
et/ou
une zone environnante autour du capteur à effet Hall (82), comprenant de préférence le deuxième aimant permanent (83), étant blindée magnétiquement au moins sur les côtés opposés au premier aimant permanent (81) au moyen d'un blindage (80).

12. Système de dosage selon l'une des revendications 7 à 11, dans lequel une douille de boîtier (6) est montée de manière réglable par rapport au boîtier environnant (2) du système de dosage (1) afin de régler une distance entre la soupape (16) et l'élement de fermeture (51) dans la position.

13. Système de dosage selon l'une des revendications précédentes, dans lequel le levier de transmission (20) est monté de manière basculante sur un axe de basculement (R) sous la forme d'un arbre (4) sur un côté tourné vers l'actionneur piézoélectrique (10), lequel arbre (4) est à son tour fixé à chaque extrémité dans un palier de levier (3),
l'actionneur piézoélectrique (10) étant disposé, pour ouvrir la soupape (16), à proximité de l'axe de basculement, au niveau d'un point d'attaque de l'actionneur (24), à angle droit par rapport à l'axe de basculement (R) sur le levier de transmission (20), en formant un palier à roulement.

14. Système de dosage selon la revendication 13, dans lequel le levier de transmission (20) est conçu et disposé de telle sorte que, dans une position initiale hors tension de l'actionneur piézoélectrique (10), le dispositif à poussoir (40) est serré contre l'actionneur piézoélectrique (10) par l'intermédiaire du levier de transmission (20) contre l'actionneur piézoélectrique (10) de telle sorte qu'un point d'attaque (24) de l'actionneur piézoélectrique (10) sur le levier de transmission (20) soit aligné avec une surface de roulement de l'arbre (4) de l'axe de basculement (R) vers le levier de transmission (20) et les coques sphériques (49) sur la bride (47) de la partie de douille de tête (45) dans les calottes sphériques (26) sur le levier de transmission (20).

15. Système de dosage selon l'une des revendications 3 à 14, dans lequel l'élément de fermeture (51) est monté de manière amovible dans le système de dosage (1), de préférence avec l'unité fluidique (15).
